# FASCICULE DE BREVET EUROPEEN

(11) **EP 3 349 548 B1**
(45) Date de publication et mention de la délivrance du brevet: **10.09.2025**
(21) Numéro de dépôt: 18151037.1
(22) Date de dépôt: 10.01.2018
(51) Int. Cl.: H05K 1/09, H05K 3/00, H05K 3/12

(54) **DISPOSITIF COMPRENANT UN SUBSTRAT APTE À ÊTRE THERMOFORMÉ SUR LEQUEL EST AGENCÉ UN ORGANE ÉLECTRIQUEMENT CONDUCTEUR**
VORRICHTUNG, DIE EIN WÄRMEFORMBARES SUBSTRAT UMFASST, AUF DEM EIN ELEKTRISCH LEITENDES ELEMENT ANGEORDNET IST
DEVICE COMPRISING A SUBSTRATE CAPABLE OF BEING THERMOFORMED, ON WHICH AN ELECTRICALLY CONDUCTIVE MEMBER IS ARRANGED

(30) Priorité: 12.01.2017 FR 1750269
(43) Date de publication de la demande: 18.07.2018
(73) Titulaire: Commissariat à l'Energie Atomique et aux Energies Alternatives, 75015 Paris (FR)
(72) Inventeur: BENWADIH, Mohammed, 94500 CHAMPAGNY SUR MARNE (FR)
(74) Mandataire: Germain Maureau

(56) Documents cités:
- WO-A1-2016/060838
- JP-A- 2008 198 425
- US-A1- 2009 294 739
- US-A1- 2010 119 789

## Description

### Domaine de l'invention

Le domaine de l'invention concerne les dispositifs thermoformables, et plus particulièrement le thermoformage d'un dispositif équipé d'un organe électriquement conducteur apte à présenter une conduction électrique après thermoformage.

### Etat de la technique

Dans le domaine de l'électronique, il est connu de former des pistes électriquement conductrices qui peuvent délimiter au moins en partie une antenne ou encore une inductance. Les techniques de dépôt de la microélectronique sont adaptées mais coûteuses et limitées à des supports rigides. Il existe donc un besoin de diminuer les coûts des opérations pour former les pistes électriquement conductrices, et de permettre la formation de telles pistes sur des supports par exemple flexibles et aptes à être thermoformés en fonction des besoins.

Dans l'optique de diminution des coûts, il a été développé des solutions d'impression de pistes électriquement conductrices à base d'encres. Outre l'avantage de diminution des coûts, de telles encres peuvent aussi être soumises à sollicitations après leur séchage ce qui rend possible le dépôt sur substrat flexible.

Le document « Investigation of RFID tag Antennas printed on flexible substrates using two types of conductive pastes » de Kamil Janeczek et al. publié dans IEEE « Electronic System-Integration Technology Conference (ESTC) », 2010 3rd - conférence du 13-16 Septembre 2010 qui s'est tenue à Berlin, propose d'utiliser une pâte comprenant de l'argent mélangé à un polymère. Le polymère permet une certaine flexibilité, mais présente l'inconvénient de dégrader la conductivité électrique et de créer des capacités parasites. Il en résulte la formation d'antennes de qualité moyenne puisque le facteur de qualité d'une antenne est dépendant de sa conductivité électrique.

Par ailleurs, en fonction des applications, il peut être envisagé d'intégrer une piste électriquement conductrice, formant par exemple une antenne, dans un endroit ayant une forme bien particulière, comme par exemple une coque de téléphone mobile. Pour une telle intégration, il est possible d'avoir recours au thermoformage d'un substrat sur lequel est formée la piste. En fonction de la forme liée au thermoformage, il en résulte une problématique de continuité électrique au sein de la piste car cette dernière peut présenter, après thermoformage, des ruptures ou fissures néfastes à la conduction du courant. Les fournisseurs d'encre privilégient essentiellement la voie particules plus polymère qui à leurs yeux a le plus de chance de passer l'étape thermoformage.

On comprend donc qu'il existe un besoin de développer de nouvelles solutions permettant d'améliorer la continuité électrique au sein d'un organe électriquement conducteur, notamment après thermoformage d'un dispositif comportant un substrat sur lequel est formé l'organe électriquement conducteur. Il est aussi connu de l'état de la technique les documents WO2016/060838 et US2010/0119789 qui proposent des encres thermoformables adaptées pour des dispositifs thermoformés.

### Objet de l'invention

L'invention a pour but de proposer un dispositif destiné à se déformer, notamment par thermoformage, et comportant un organe électriquement conducteur apte à présenter une conduction électrique satisfaisante même après sa déformation. On cherche donc à trouver une solution permettant de répondre à la problématique d'amélioration de la conductivité électrique de l'organe électriquement conducteur en particulier lorsque ce dernier est destiné à être sollicité thermiquement et mécaniquement.

On tend vers ce but grâce à un dispositif destiné à être thermoformé comportant un substrat apte à être thermoformé et un organe électriquement conducteur solidaire dudit substrat. Ce dispositif est tel que défini par la revendication 1, et l'organe électriquement conducteur comporte des particules électriquement conductrices, un matériau électriquement conducteur, et des éléments de forme allongée électriquement conducteurs. Par ailleurs, le matériau électriquement conducteur présente une température de fusion strictement inférieure à la température de fusion des particules électriquement conductrices et à la température de fusion des éléments de forme allongée.

De préférence, les éléments de forme allongée ont une longueur supérieure ou égale à 20µm.

De préférence, au moins l'un des éléments de forme allongée adopte une configuration repliée.

Selon une réalisation, l'organe électriquement conducteur comporte au moins un élément de liaison comportant au moins une portion du matériau électriquement conducteur, obtenue par fusion puis solidification du matériau électriquement conducteur, chaque élément de liaison reliant au moins une des particules électriquement conductrices à au moins un des éléments de forme allongée.

Selon une mise en œuvre, l'organe électriquement conducteur comporte un empilement de couches comportant une première couche et une deuxième couche agencée sur la première couche, la première couche étant interposée entre le substrat et la deuxième couche. La première couche comporte une partie des éléments de forme allongée. La deuxième couche comporte une autre partie des éléments de forme allongée, les particules électriquement conductrices et le matériau électriquement conducteur.

Alternativement, l'organe électriquement conducteur peut comporter un empilement de couches comportant une première couche et une deuxième couche agencée sur la première couche. La première couche est interposée entre le substrat et la deuxième couche. La première couche comporte les éléments de forme allongée. La deuxième couche comportant les particules électriquement conductrices et le matériau électriquement conducteur.

Selon une autre mise en œuvre, l'organe électriquement conducteur comporte un empilement de couches comprenant une couche comportant les particules électriquement conductrices, une couche comportant le matériau électriquement conducteur, et une couche comportant les éléments de forme allongée.

Selon encore une autre mise en œuvre, l'organe électriquement conducteur comporte des premières parties comportant chacune une partie correspondante des particules électriquement conductrices, et des deuxièmes parties comportant chacune une partie correspondante des éléments de forme allongée. Le matériau électriquement conducteur est présent dans les premières parties et/ou dans les deuxièmes parties. L'organe électriquement conducteur comporte un empilement de couches comportant une première couche munie d'au moins une des premières parties et d'au moins une des deuxièmes parties, et une deuxième couche agencée sur la première couche. La deuxième couche est munie d'au moins une des premières parties et d'au moins une des deuxièmes parties. Chaque deuxième partie étant à distance des autres deuxièmes parties.

Avantageusement, le substrat présente, à son interface avec l'organe électriquement conducteur, une structuration en creux.

De préférence, les éléments de forme allongée sont formés par des nanofils et/ou des nanotubes et/ou des feuillets de graphène, et/ou des éléments de forme allongée comportant une âme en polymère recouverte en tout ou partie par une couche électriquement conductrice.

De préférence, les éléments de forme allongée ont une longueur strictement supérieure à la taille des particules électriquement conductrices.

L'invention est aussi relative à un procédé d'utilisation d'un dispositif destiné à être thermoformé tel que décrit, ce procédé comporte une phase de thermoformage comportant : une étape de chauffe dudit dispositif de sorte à autoriser une mise en forme du substrat du dispositif, une étape de mise en forme du substrat selon une forme prédéterminée au cours de laquelle ledit organe électriquement conducteur reste lié audit substrat, une étape de refroidissement au terme de laquelle il est formé un dispositif thermoformé comportant le substrat adoptant la forme prédéterminée.

Le procédé peut comporter une étape de fourniture d'un objet comportant la forme prédéterminée, et l'étape de mise en forme comporte successivement : une étape de projection d'un fluide gazeux de sorte à étirer le substrat du dispositif chauffé, et une étape d'aspiration permettant de plaquer le dispositif contre l'objet de sorte que ledit dispositif épouse au moins une partie de la surface dudit objet.

Le procédé peut comporter une étape de chauffe additionnelle du dispositif, mise en œuvre après l'étape de refroidissement, à une température permettant de faire fondre le matériau électriquement conducteur.

De préférence, l'étape de chauffe provoque le passage du matériau électriquement conducteur d'un état solide à un état liquide.

Selon une implémentation, au terme de l'étape de refroidissement l'organe électriquement conducteur comporte un assemblage de particules électriquement conductrices et d'éléments de forme allongée solidarisés par du matériau électriquement conducteur.

L'invention est aussi relative à un dispositif thermoformé comportant un substrat, dont la forme a été obtenue par thermoformage, et un organe électriquement conducteur solidaire dudit substrat. L'organe électriquement conducteur comporte des particules électriquement conductrices, des éléments de forme allongée électriquement conducteurs, et un matériau électriquement conducteur présentant une température de fusion strictement inférieure à la température de fusion des particules électriquement conductrices et à la température de fusion des éléments de forme allongée. L'organe électriquement conducteur peut comporter un assemblage de particules électriquement conductrices et d'éléments de forme allongée solidarisés par du matériau électriquement conducteur.

L'invention est aussi relative à un procédé de fabrication d'un dispositif destiné à être thermoformé, le procédé de fabrication comportant une étape de fourniture du substrat, et une étape de formation de l'organe électriquement conducteur mettant en œuvre au moins une étape de dépôt d'une encre sur le substrat.

### Description sommaire des figures

L'invention sera mieux comprise à la lecture de la description qui va suivre, donnée uniquement à titre d'exemple non limitatif et faite en se référant aux dessins sur lesquels :
- La figure 1 illustre schématiquement un dispositif destiné à être thermoformé en perspective,
- La figure 2 illustre une vue en coupe de la figure 1 selon la coupe A-A,
- La figure 3 est un exemple d'élément de forme allongée vu selon une coupe longitudinale dudit élément de forme allongée,
- La figure 4 illustre des étapes d'un procédé d'utilisation permettant le thermoformage du dispositif,
- La figure 5 illustre un dispositif thermoformé,
- La figure 6 illustre un élément de liaison liant une particule à un élément de forme allongée,
- Les figures 7 à 10 illustrent des vues en coupe du type de la coupe A-A de la figure 1 pour différentes réalisations de dispositifs destinés à être thermoformés,
- Les figures 11 à 13 illustrent différentes étapes du procédé d'utilisation permettant le thermoformage du dispositif,
- La figure 14 illustre un procédé de fabrication d'un dispositif destiné à être thermoformé.

Dans ces figures, les mêmes références sont utilisées pour désigner les mêmes éléments.

Les figures sont des vues schématiques.

Par ailleurs, les éléments représentés sur les figures ne sont pas nécessairement à l'échelle.

### Description de modes particuliers de réalisation

Il est décrit ci-après un dispositif destiné à être déformé, notamment thermoformé, et permettant d'assurer, même après la déformation, une continuité électrique au sein d'un organe, ou piste, électriquement conducteur que comporte le dispositif. Après thermoformage, on parle de dispositif thermoformé. Pour cela, l'organe électriquement conducteur comporte judicieusement des particules électriquement conductrices, un matériau électriquement conducteur en particulier destiné à subir une fusion au cours du thermoformage ou ultérieurement au thermoformage, et des éléments de forme allongée électriquement conducteurs qui permettrons d'assurer la continuité électrique entre des particules électriquement conductrices s'étant éloignées lors de la déformation, notamment grâce la fusion du matériau électriquement conducteur. En particulier, cette fusion du matériau électriquement conducteur permet, en combinaison avec l'allongement des éléments de forme allongée, de connecter des particules électriquement conductrices entre elles suite à un étirement/déformation d'un substrat sur lequel est formé l'organe électriquement conducteur.

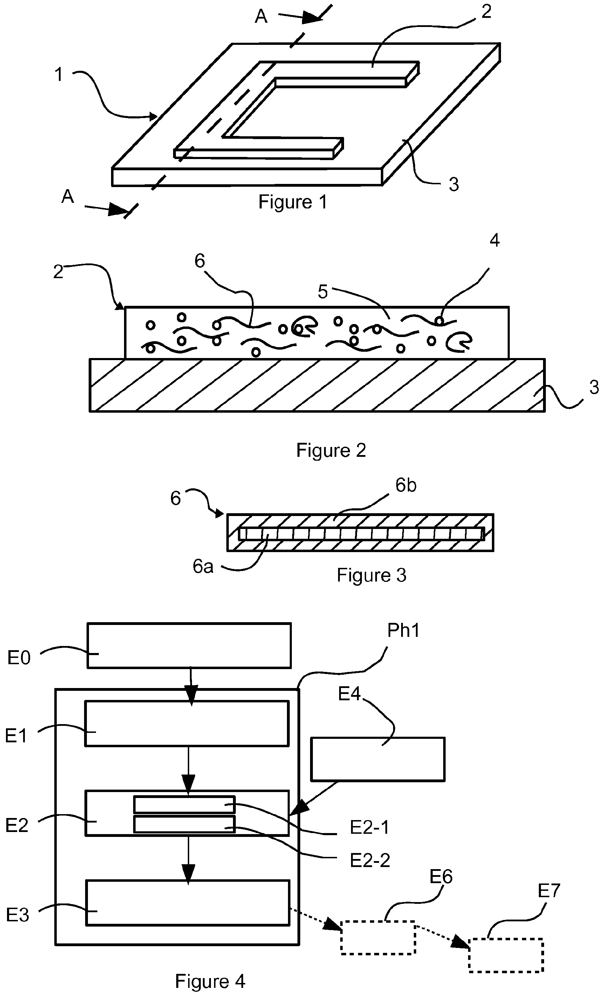

La figure 1 illustre schématiquement un dispositif 1 destiné à être thermoformé. Ce dispositif 1 comporte un organe électriquement conducteur 2 et un substrat 3 apte à (c'est-à-dire configuré de sorte à) être thermoformé, ledit organe électriquement conducteur 2 étant solidaire du substrat 3. Par « solidaire du substrat » on entend que l'organe électriquement conducteur 2 est agencé/formé sur le substrat 3, c'est-à-dire qu'il est lié audit substrat 3.

L'organe électriquement conducteur 2 peut être une piste électriquement conductrice. Cet organe électriquement conducteur 2, et donc le cas échéant la piste, peut être une antenne, ou une inductance, en particulier obtenue par impression sur le substrat 3. L'antenne peut être choisie parmi : une antenne filaire (dipôle, monopôle, Yagi), une antenne à fentes (demi ou quart d'onde), une antenne patch (planaire), une antenne à ouverture (cornet), et une antenne à réflecteur (parabole). Les types d'antenne donnés ici ne sont pas limitatifs.

Classiquement, une antenne permet d'établir un lien radio depuis un émetteur vers un récepteur. En émission, une antenne permet de transformer un signal électrique en onde électromagnétique, et en réception c'est l'inverse.

Un paramètre important pour la réalisation d'une antenne performante étant sa conductivité électrique, on comprend qu'il est important que cette conductivité électrique soit toujours bonne après thermoformage.

Le substrat 3 apte à être thermoformé peut être un substrat 3 comportant, ou constitué par, du polycarbonate (PC), ou un substrat comportant, ou constitué par, du polycarbonate Acrylonitrile Butadiène Styrène (PC/ABS), ou un substrat comportant, ou constitué par, du polyéthylène (PE). D'autres matériaux pourront être utilisés pour former le substrat 3 du moment qu'ils peuvent assurer la fonction recherchée, c'est-à-dire permettre un ramollissement de tout ou partie du substrat lorsqu'il est soumis à une température prédéterminée autorisant sa mise en forme, et permettre au substrat de conserver la mise en forme lorsque le substrat est refroidi et redevient dur. Autrement dit, par « substrat 3 apte à être thermoformé ou substrat thermoformable », on entend dans la présente description un substrat ou support qui peut être thermoformé, c'est-à-dire mis en forme sous l'effet de la chaleur et notamment sous sollicitation mécanique. Un tel substrat 3 peut donc présenter des propriétés lui permettant de s'étirer tout en adoptant une forme particulière lorsqu'il est chauffé. Par exemple, lorsque le substrat 3 est en polycarbonate, la température à laquelle le thermoformage est réalisé est généralement de 150°C. Le substrat 3 peut présenter une épaisseur comprise entre 75µm et 1mm, et notamment comprise entre 175µm et 250µm, par exemple égale à 175µm ou 250µm. Plus l'épaisseur du substrat est faible, plus sa mise en forme par thermoformage est facilitée.

Le thermoformage est une technique qui consiste à prendre un matériau sous forme de substrat comme par exemple une plaque (dans notre cas préférentiellement un plastique), à le chauffer pour le ramollir, et à profiter de cette ductilité pour le mettre en forme avec un objet tel un moule. Le matériau durcit à nouveau lorsqu'il refroidit, gardant la forme du moule qui peut correspondre à la forme d'une coque d'un appareil électronique. Le thermoformage est basé sur le phénomène de transition vitreuse des thermoplastiques. Le substrat peut être en matériau thermoplastique. En effet, leur température de transition vitreuse passée, les matériaux thermoplastiques sont à l'état de type caoutchouc, il devient alors facile de leur donner une nouvelle forme. Une fois la température descendue en dessous de la transition vitreuse, le matériau thermoplastique (par exemple un polymère) retourne à l'état solide (vitreux) et conserve sa nouvelle forme. Le thermoformage se déroule généralement selon les phases suivantes : chauffage de la matière ; mise en forme de la matière sur le moule (par le vide, ou sous pression) ; refroidissement (la pièce reste sur le moule) ; démoulage et évacuation de la pièce finale.

Selon la présente invention, dans le cas du thermoformage plastique, le substrat 3 utilisé se présente le plus souvent sous la forme d'une feuille plastique sur laquelle est formé l'organe électriquement conducteur 2, par exemple l'antenne, que l'on thermoforme sur une coque plastique généralement en ABS (pour Acrylonitrile Butadiène Styrène) ou PC/ABS.

Grâce au thermoformage, il est possible d'intégrer facilement une antenne à l'intérieur d'un appareil électronique (comme par exemple un téléphone mobile ou autre). En effet, il est ici possible d'intégrer une antenne sur un substrat apte à être thermoformé afin d'avoir un module d'antenne qui pourra ensuite facilement être intégré à un boîtier après thermoformage du substrat sur lequel est formée l'antenne.

L'organe électriquement conducteur 2 étant solidaire du/formé sur le substrat 3, lors du thermoformage ledit organe 2 continue d'épouser le substrat 3 du fait qu'il est capable de subir des contraintes sans rompre, ou du fait de caractéristiques fusibles d'au moins une partie de cet organe électriquement conducteur. Cette capacité et ces caractéristiques sont liées à la composition de l'organe électriquement conducteur qui est décrite ci-après. L'organe électriquement conducteur peut être solidaire du substrat 3 avant, pendant et après le thermoformage via les forces de Van der Waals.

Comme l'illustre schématiquement la figure 2, l'organe électriquement conducteur 2 comporte des particules électriquement conductrices 4 (aussi appelées particules 4 dans la suite de la description), un matériau électriquement conducteur 5, des éléments de forme allongée 6 électriquement conducteurs (aussi simplement appelés éléments de forme allongée 6 dans la présente description). Les particules 4, les éléments de forme allongée 6 et le matériau électriquement conducteur 5 sont des choses distinctes. Le matériau électriquement conducteur 5 présente (c'est-à-dire qu'il a) une température de fusion strictement inférieure à la température de fusion des particules électriquement conductrices 4 et à la température de fusion des éléments de forme allongée 6. On comprend aussi de ce qui a été dit ci-dessus que le substrat 3 peut être associé à une température de thermoformage qui correspond à la température à laquelle il se présente sous une forme ramollie/ductile autorisant la modification de sa forme. En particulier, la température de fusion du matériau électriquement conducteur 5 est inférieure ou égale à la température de thermoformage du substrat 3 ce qui permet avantageusement de faire fondre le matériau électriquement conducteur 5 lors du thermoformage. Par ailleurs, la température de thermoformage est strictement inférieure à la température de fusion des particules électriquement conductrices 4 et à la température de fusion des éléments de forme allongée 6. Selon une alternative, la chauffe du dispositif permettant de mettre en forme le substrat pour le thermoformer est réalisée en un temps ne permettant pas la fonte ou la fonte adéquate du matériau électriquement conducteur. Selon cette alternative, on réalise dans un premier temps la mise en forme du substrat, puis après la mise en forme on réalise une étape de chauffe additionnelle, notamment au cours de laquelle la forme du substrat acquise lors de la mise en forme est conservée, permettant de faire fondre le (c'est-à-dire provoquant la fonte ou fusion du) matériau électriquement conducteur en vue d'améliorer la conduction électrique de l'organe électriquement conducteur par établissement d'un lien électriquement conducteur entre des particules électriquement conductrices via du matériau électriquement conducteur.

En particulier, comme il le sera détaillé par la suite, les particules électriquement conductrices 4 permettent de conférer à l'organe électriquement conducteur une résistance électrique adaptée à son utilisation. Au moins une partie des éléments de forme allongée 6 et du matériau électriquement conducteur 5 sont configurés pour relier des particules 4 entre elles après thermoformage. Notamment le matériau électriquement conducteur permet de connecter, par exemple par brasure, des particules électriquement conductrices 4 à des éléments de forme allongée 6 et des éléments de forme allongée 6 entre eux.

Concernant la réalisation de la figure 2, l'organe électriquement conducteur peut comporter une seule couche comportant un mélange des particules électriquement conductrices 4, du matériau électriquement conducteur 5 et des éléments de forme allongée 6 qui forment un ensemble cohérent électriquement conducteur et attaché au substrat 3, notamment via les forces de Van der Waals et avantageusement grâce à un traitement appliqué au substrat 3 permettant d'améliorer l'adhérence entre le substrat 3 et l'organe électriquement conducteur 2. Le traitement visé ci-avant peut être un traitement plasma ou UV (pour Ultraviolets) ozone appliqué au substrat. L'UV ozone permet de libérer des liaisons du substrat tel OH- et COOH qui permettent de venir réagir, le cas échéant avec des espèces organiques présentes dans une encre utilisée pour former l'organe électriquement conducteur comme par exemple un liant polymère utilisé dans l'encre, ou des restes de résidus ou de précurseurs organiques non décomposés thermiquement présents dans la formulation de l'encre. De plus l'UV ozone crée une petite rugosité nanométrique du substrat qui améliore sensiblement l'adhérence de future(s) couche(s) que l'on va déposer sur le substrat pour former l'organe électriquement conducteur. Ce traitement du substrat peut donc s'appliquer à tous les modes de réalisation qui seront décrits ci-après de sorte à améliorer l'adhérence entre le substrat et l'organe électriquement conducteur.

Par « température de fusion du matériau électriquement conducteur », on entend la température à laquelle le matériau électriquement conducteur passe d'un état solide à un état liquide. Par « température de fusion des particules électriquement conductrices 4 », on entend la température à laquelle les particules électriquement conductrices 4 peuvent passer d'un état solide à un état liquide. Par « température de fusion des éléments de forme allongée », on entend la température à laquelle les éléments de forme allongée 6 peuvent passer d'un état solide à un état liquide.

Dans la présente description, les températures de fusion sont données à la pression atmosphérique. Autrement dit, les températures de fusion dans la présente description sont comparées selon une même pression. Par ailleurs, lorsque la température de thermoformage est comparée à une température de fusion, elles sont comparées pour une même pression.

De préférence, le dispositif destiné à être thermoformé est configuré de sorte à adopter, lorsqu'il est chauffé à une température prédéterminée aussi appelée température de thermoformage, une configuration dans laquelle le matériau électriquement conducteur 5 est à l'état liquide, les particules électriquement conductrices 4 et les éléments de forme allongée 6 sont à l'état solide, et le substrat 3 est dans un état autorisant sa mise en forme : c'est-à-dire un état malléable ou ductile. Selon une alternative, la température prédéterminée est telle que le matériau électriquement conducteur 5 est à l'état liquide, les particules électriquement conductrices 4, les éléments de forme allongée 6 et le substrat 3 sont à l'état solide. Cette alternative est notamment mise en œuvre par une étape de chauffe additionnelle notamment réalisée ultérieurement au thermoformage.

Par « élément de forme allongée 6 » on entend dans la présente description un élément qui présente une forme longue, de préférence une longueur strictement supérieure à ses dimensions mesurées selon un plan de coupe orthogonal à sa direction d'allongement. Un élément de forme allongée 6 peut adopter une configuration déployée dans laquelle il s'étend selon sa longueur, par exemple où il est rectiligne ou sensiblement rectiligne, et une configuration repliée/courbée dans laquelle il présente, selon son allongement, des courbes. Dans la configuration repliée, l'élément de forme allongée 6 peut être enroulé sur lui-même. Dans le cadre du dispositif destiné à être thermoformé, au moins l'un des éléments de forme allongée 6 peut adopter une configuration repliée, notamment plusieurs des, voir tous les, éléments de forme allongée 6 peuvent adopter la configuration repliée au sein de l'organe électriquement conducteur 2 du dispositif destiné à être thermoformé. Ceci présente l'avantage de faciliter les connexions électriques au sein de l'organe électriquement conducteur 2 au terme du thermoformage car l'élément de forme allongée 6 va naturellement avoir tendance à se déployer au cours du thermoformage du fait d'un étirement du substrat 3 (avec ou sans fusion du matériau électriquement conducteur 5), et permettra à l'élément de forme allongée 6 de participer à la liaison électrique de particules 4 pouvant s'être éloignées. Par ailleurs, lors du thermoformage ou d'un étirement du substrat, les éléments de forme allongée vont naturellement avoir tendance à s'aligner en fonction du thermoformage ou de l'étirement ce qui permettra par la suite d'améliorer les reconnexions de particules électriquement conductrices 4.

En ce sens, la forme allongée des éléments 6 permet à ces derniers d'absorber les sollicitations dues à la déformation et de participer préférentiellement à la formation d'un lien ou chemin électriquement conducteur entre des particules électriquement conductrices 4 qui peuvent s'éloigner les unes des autres lors du thermoformage du dispositif. Pour améliorer cette fonction de connexion de particules entre elles, les éléments de forme allongée 6 ont une longueur strictement supérieure à la taille, aussi appelée la dimension maximale, des particules électriquement conductrices 4. Autrement dit, chaque élément de forme allongée 6 a une longueur strictement supérieure à la taille, ou dimension maximale, de chacune des particules électriquement conductrices 4.

Les éléments de forme allongée 6 ont préférentiellement une longueur supérieure ou égale à 20µm. Pour chaque élément de forme allongée, sa longueur peut être comprise de manière non limitative entre 20µm et 100µm, ou plus généralement entre 5µm et 1000µm, en fait la longueur dépendra du type d'élément de forme allongée comme on le verra par la suite. De préférence, les éléments de forme allongée 6 présentent une longueur supérieure ou égale à l'étirement du substrat 3 qui sera réalisé lors du thermoformage, ceci permet d'améliorer la conductivité électrique de l'organe électriquement conducteur 2 après thermoformage en évitant la formation de ruptures de conductivité électrique au sein de l'organe électriquement conducteur 2. En effet, la présence d'éléments de forme allongée 6 permet, en cas d'étirement du substrat 3, à au moins certaines des particules électriquement conductrices 4 de glisser le long d'éléments de forme allongée 6. Ces particules 4 sont notamment connectées, après fusion du matériau électriquement conducteur 5, à au moins un des éléments de forme allongée 6 par du matériau électriquement conducteur 5 ayant subi une fusion.

Les éléments de forme allongée 6 peuvent présenter des dimensions latérales, ou un diamètre, compris entre 5nm et 1µm, préférentiellement compris entre 10nm et 100nm. D'autres dimensions sont aussi envisagées comme il le sera vu par la suite.

En particulier, les éléments de forme allongée 6 peuvent être des nanofils ou des nanotubes électriquement conducteurs, notamment de longueur comprise entre 20µm et 100µm et de largeur comprise entre 10nm et 100nm. Pour cela, les nanofils peuvent être des nanofils d'argent, ou de cuivre, ou de nickel, ou d'or, ou encore de carbone dopés électriquement. Dans le cas où les éléments de forme allongée sont des nanotubes de carbone, leur longueur peut être comprise entre 20µm et 1000µm et leur largeur comprise entre 10nm et 100nm.

Les éléments de forme allongée 6 peuvent aussi être des nanotubes de carbone dopés électriquement pour assurer la fonction de conductivité électrique de ces éléments de forme allongée 6.

Les éléments de forme allongée peuvent aussi se présenter sous la forme de feuillets allongés (par exemple une couche en 2D en graphène) de graphène. Ici, un feuillet allongé peut être une monocouche atomique en graphène (d'épaisseur maximale 1nm) et dont la surface d'une face principale peut aller de 5µmx5µm jusqu'à 100µmx100µm.

Selon encore une autre réalisation (figure 3), les éléments de forme allongée 6 peuvent comporter une âme 6a en polymère par exemple comportant du polystyrène (PS), ou du polybutadiène, ou du Polyméthacrylate de méthyle (PMMA), ou du Polydiméthylsiloxane (PDMS). Cette âme 6a est recouverte en tout ou partie par une couche électriquement conductrice 6b conférant aux éléments de forme allongée 6 leur fonction de conductivité électrique. La couche électriquement conductrice 6b peut comporter un matériau choisi parmi : Ag, Cu, Ni, Au, et un polymère conducteur pedot-pss (il s'agit notamment d'un mélange du polymère PEDOT aussi connu sous la dénomination poly(3,4-éthylènedioxythiophène) et du polymère PSS aussi connu sous la dénomination poly(styrène sulfonate) de sodium). Autrement dit, la couche 6b peut former une gaine d'enrobage de l'âme 6a. Selon cette réalisation, l'âme 6a peut présenter une épaisseur comprise entre 10nm et 500nm, une largeur selon une direction orthogonale à la direction selon laquelle l'épaisseur est mesurée comprise entre 1µm et 50µm, et une longueur comprise entre 10µm et 500µm. De tels éléments de forme allongée 6 sont préférés car ils sont plus faciles à fabriquer, et peuvent présenter des dimensions par exemple en largeur et en longueur plus importantes. Un autre avantage est que de tels éléments de forme allongée 6 peuvent être élastiques ce qui est un plus dans l'application car l'organe électriquement conducteur pourra plus facilement subir des efforts sans se dégrader. Par ailleurs, un élément de forme allongée 6 comprenant du polymère est très facile à fabriquer et les dimensions peuvent être très larges alors qu'un nanofil d'argent sera plus dur à obtenir avec des dimensions de l'ordre de 500µm de long. L'épaisseur de la couche électriquement conductrice recouvrant l'âme est préférentiellement supérieure à 25nm, et de préférence comprise entre 35nm et 100nm, pour assurer une fonction satisfaisante de conduction électrique.

En particulier, au sein d'un même organe électriquement conducteur 2, les éléments de forme allongée 6 peuvent être de même type ou de types différents. Autrement dit, chaque élément de forme allongée 6 peut être choisi, indépendamment des autres éléments de forme allongée, parmi les différentes possibilités évoquées dans la présente description. Ainsi, les éléments de forme allongée 6 peuvent par exemple être formés par des nanofils et/ou des nanotubes et/ou des feuillets de graphène, et/ou des éléments de forme allongée comportant une âme 6a en polymère recouverte en tout ou partie par une couche électriquement conductrice 6b.

Notamment, les dimensions des éléments de forme allongée 6 sont adaptées pour permettre un dépôt de ces derniers par impression en vue de former l'organe électriquement conducteur.

Les particules électriquement conductrices 4 peuvent comporter un métal ou être constituées par un métal. Le métal peut être choisi parmi l'argent, l'or, le nickel, le cuivre, le platine et le palladium. En ce sens, les particules électriquement conductrices peuvent être des particules métalliques. Les particules électriquement conductrices 4 peuvent comporter toutes le même métal ou des métaux différents. Autrement dit, chaque particule électriquement conductrice peut comporter l'un des matériaux suivants choisi, notamment indépendamment du choix pour les autres particules, parmi : l'or, l'argent, le nickel, le cuivre, le palladium et le platine. De manière préférée, chaque particule électriquement conductrice comporte une dimension maximale (ou taille) comprise entre 10nm et 10µm, ceci permettant d'être compatible avec les techniques d'impression, par exemple par jet d'encre, de l'organe électriquement conducteur. Par ailleurs, la surface de contact entre particules de taille nanométrique est plus grande lorsque les particules sont de taille strictement inférieure à 200nm car elles s'imbriquent mieux entre elles et donc la conductivité en sera améliorée. La dimension minimale de chacune des particules électriquement conductrices peut être comprise entre 10nm et 50nm.

Les particules électriquement conductrices 4 présentent préférentiellement une conductivité électrique comprise entre 10⁴S/m et 10⁸S/m, et préférentiellement comprise entre 10⁶S/m et 10⁷S/m. En fait, les particules électriquement conductrices 4 ont pour fonction de diminuer la résistivité électrique globale de l'organe électriquement conducteur puisque théoriquement ce sont elles qui conduisent le mieux.

Le matériau électriquement conducteur 5 est un matériau fusible, c'est-à-dire apte à fondre sous l'action de la chaleur. Le matériau électriquement conducteur 5 peut se présenter sous la forme de particules fusibles dispersées au sein de l'organe électriquement conducteur 2, ou peut se présenter sous la forme d'éléments de liaison indépendants ou appartenant à une même couche en matériau électriquement conducteur 5 et liant électriquement des éléments de forme allongée 6 à des particules électriquement conductrices 4. Dans la présente description, lorsqu'il est fait référence à des éléments de liaison comportant au moins une portion du matériau électriquement conducteur 5, ces derniers peuvent être reliés par une continuité de matière en matériau électriquement conducteur. Lorsque le matériau électriquement conducteur 5 se présente sous la forme de particules fusibles, c'est à dire avant qu'il subisse une fusion par exemple au cours du thermoformage, les particules fusibles peuvent présenter des dimensions comprises entre 2,5µm et 25µm, notamment un rayon de 7,5 µm, ces dimensions étant notamment compatibles avec les techniques d'impression.

Plus particulièrement, le matériau électriquement conducteur 5 est destiné à connecter des particules électriquement conductrices 4 avec des éléments de forme allongée 6 dans le cadre du dispositif thermoformé. Autrement dit, le matériau électriquement conducteur 5 est destiné à lier, notamment après thermoformage du dispositif, mécaniquement et électriquement au moins une partie des particules électriquement conductrices à des éléments de forme allongée 6 correspondants.

A titre d'exemple non limitatif, le matériau électriquement conducteur 5 peut être :
- un alliage de Darcet : Bi₅₀Pb₂₅Sn₂₅ dont la température de fusion est de 94°C,
- un alliage de Newton : Bi₅₀Pb₃₁Sn₁₉ dont la température de fusion est de 94°C,
- du Sn43Pb43Bi14 ou du Sn42Bi58 avec des eutectiques entre 138°C et 163°C,
- choisi parmi les alliages eutectiques binaires Bi-Pb à teneur en Bi comprise entre 55% et 58 %, le pourcentage donnant ici les proportions massiques, et à température de fusion comprise entre 124°C et 125 °C,
- en Indium dont la température de fusion est de 156°C,
- un alliage appartenant à la famille des eutectiques Au_Sn dans différentes proportions par exemple 20% d'or et 80% de Sn avec le pourcentage donnant ici les proportions massique, ou autres du moment que la température de fusion est inférieure à 250°C pour être compatible avec de nombreux substrats plastiques,
- choisi parmi les alliages comprenant de l'argent et du bismuth ou autres de cette famille,
- choisi parmi l'un des alliages suivant Sn-Ag-Cu, Sn-Pb ou Sn-Pb-Ag,
- choisi dans la famille de l'indium, bismuth, étain, plomb.

Les températures de fusion données ci-dessus sont notamment celles dans les conditions de mise en œuvre du thermoformage, ou alternativement ultérieurement à la mise en forme du substrat ou au thermoformage, et sont données à la pression atmosphérique.

Les exemples donnés ci-dessus ne sont pas limitatifs, en effet tout type de matériau électriquement conducteur 5 apte à fondre au cours du thermoformage du dispositif peut être utilisé. Plus particulièrement, le matériau électriquement conducteur 5 est choisi de telle sorte à présenter une température de fusion comprise entre 90°C et 210°C, ou plus particulièrement entre 100°C et 210°C à la pression atmosphérique.

Dans le cadre du dispositif destiné à être thermoformé, la conduction électrique de l'organe électriquement conducteur 2 peut être réalisée par la mise en contact de particules électriquement conductrices 4 entre elles et avec le matériau électriquement conducteur 5 et/ou des éléments de forme allongée 6.

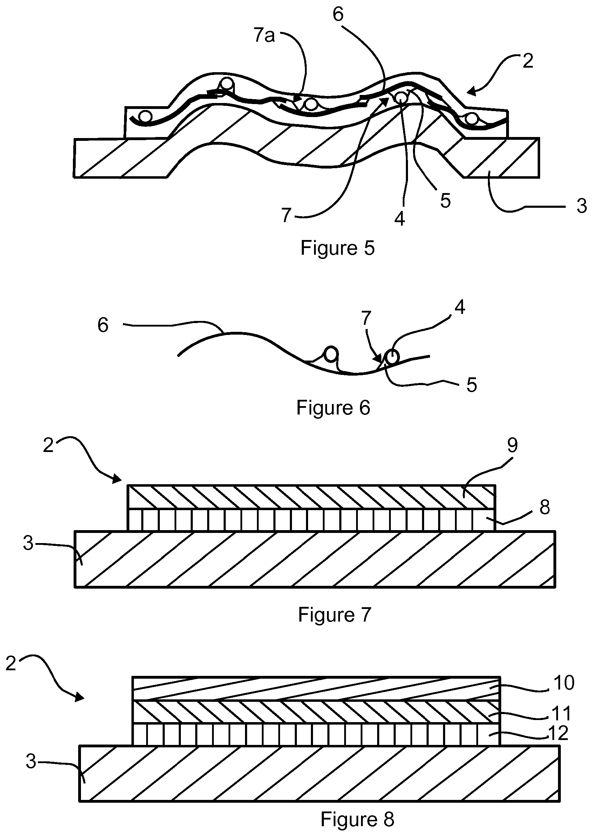

On comprend de tout ce qui a été dit ci-dessus que l'invention est aussi relative à un procédé d'utilisation, aussi appelé procédé de traitement, d'un dispositif destiné à être thermoformé tel que décrit, notamment au terme duquel on obtient un dispositif thermoformé. En fait, le procédé d'utilisation ou de traitement permet de partir du dispositif destiné à être thermoformé de sorte à s'en servir pour le thermoformer. Le procédé d'utilisation comporte comme illustré en figure 4 une phase de thermoformage Ph1 comprenant : une étape de chauffe E1 dudit dispositif de sorte à autoriser une mise en forme du substrat 3 du dispositif (l'étape de chauffe E1 permet alors d'amener le dispositif, et notamment le substrat 3, à sa température de thermoformage), et de préférence provoquant le passage du matériau électriquement conducteur 5 d'un état solide à un état liquide ; une étape de mise en forme E2 du substrat du dispositif, notamment chauffé, selon une forme prédéterminée, au cours de cette étape de mise en forme E2 ledit organe électriquement conducteur 2 reste lié au substrat 3 : ledit organe électriquement conducteur 2 se déforme avec ledit substrat 3 ; une étape de refroidissement E3 du dispositif, mise en œuvre après l'étape de mise en forme E2, au terme de laquelle il est formé un dispositif thermoformé (figure 5) comportant le substrat 3 adoptant la forme prédéterminée. Dans le cadre du dispositif thermoformé le substrat 3 est à l'état solide. Ainsi, l'étape de chauffe E1 permet de ramollir, c'est-à-dire rendre ductile, le substrat 3, l'étape de mise en forme E2 permet de donner la forme prédéterminée au substrat ramolli (c'est-à-dire rendu ductile), et l'étape de refroidissement E3 permet au substrat de durcir d'où il résulte qu'il conserve la forme prédéterminée.

Au cours de l'étape de mise en forme E2 du substrat 3, le matériau électriquement conducteur 5 est, de préférence, à l'état liquide. Il en résulte que le matériau électriquement conducteur peut fluer au cours de l'étape de mise en forme E2 en vue de connecter des particules électriquement conductrice 4 à des éléments de forme allongée 6 lorsque le matériau électriquement conducteur 5 repasse à l'état solide. Par ailleurs, lorsque le matériau électriquement conducteur 5 flue, les éléments de forme allongée 6 peuvent s'orienter et les particules électriquement conductrices 4 peuvent se déplacer. On comprend que la température de chauffe appliquée au dispositif au cours de l'étape de chauffe E1 (aussi appelée température de thermoformage) peut être supérieure ou égale à la température de fusion du matériau électriquement conducteur 5 mais strictement inférieure aux températures de fusion des éléments de forme allongée 6 et des particules électriquement conductrices 4. Une forme prédéterminée correspond à une forme souhaitée.

De préférence, l'étape de refroidissement E3 permet, ou provoque, le passage du matériau électriquement conducteur de l'état liquide à l'état solide lorsque ce dernier a fondu du fait de l'étape de chauffe E1. De préférence, le dispositif thermoformé (figure 5), notamment au terme de l'étape de refroidissement E3 et dans la variante où le matériau électriquement conducteur fond lors de l'étape E1, comporte l'organe électriquement conducteur 2 solidaire du substrat 3, ledit organe électriquement conducteur 2 étant tel qu'au moins une des particules électriquement conductrices 4 est reliée à au moins un des éléments de forme allongée 6 par un élément de liaison 7 comportant au moins une portion du matériau électriquement conducteur 5. En particulier, chaque élément de forme allongée 6 peut être relié à plusieurs particules électriquement conductrices par un élément de liaison 7.

On comprend de ce qui a été dit ci-dessus que l'étape de chauffe E1 peut permettre la fonte du matériau électriquement conducteur 5 ou pas, ou encore une fonte partielle pas suffisante au but recherché de reconnexion de particules électriquement conductrices 4 avec des éléments de forme allongée 6.

Dans la présente description, lorsque l'on parle de la fonte ou de la fusion du matériau électriquement conducteur, on entend que ce dernier passe en totalité, ou au moins majoritairement, de son état solide à son état liquide.

Dans le cas où l'étape de chauffe E1 permet de mettre en œuvre la fusion du matériau électriquement conducteur 5, ce dernier va permettre de connecter, lors de son refroidissement, des particules 4 avec des éléments de forme allongée 6 en vue de former un assemblage permettant d'obtenir la conductivité recherchée de l'organe électriquement conducteur 2.

Selon une réalisation, le procédé peut comporter, après l'étape de refroidissement E3 (notamment après la phase de thermoformage PH1), une étape de chauffe additionnelle E6 (représentée en pointillés à la figure 4) du dispositif, formant alors le dispositif thermoformé, à une température permettant de faire fondre le matériau électriquement conducteur 5, notamment tout en restant en dessous des températures de fusion des particules 4 et des éléments de forme allongée 6, ainsi que de préférence en dessous de la température de thermoformage pour éviter de déformer à nouveau le substrat 3. Après une étape de refroidissement additionnelle E7 (représentée en pointillés à la figure 4), mise en œuvre après l'étape de chauffe additionnelle E6, permettant le passage du matériau électriquement conducteur de l'état liquide à l'état solide et au terme de laquelle l'organe électriquement conducteur 2 est solidaire du substrat 3, ledit organe électriquement conducteur 2 est préférentiellement tel que décrit au terme de l'étape de refroidissement E3 lorsque l'étape de chauffe E1 permet la fusion du matériau électriquement conducteur. Cette réalisation peut être mise en œuvre dans le cas où l'étape de chauffe E1 ne permet pas la fonte, ou ne permet qu'une fonte partielle non suffisante, du matériau électriquement conducteur. Au cours de l'étape E6, la forme du substrat n'est pas modifiée. En fait, l'étape de chauffe de la phase de thermoformage peut être tellement rapide que le matériau électriquement conducteur ne peut pas fondre ou ne pas fondre de manière correcte, et c'est dans ce cas que l'on applique l'étape de chauffe additionnelle et l'étape de refroidissement additionnelle.

Au terme de l'étape de refroidissement E3, ou de l'étape de refroidissement additionnelle E7, l'organe électriquement conducteur 2 peut être tel qu'il comporte un assemblage de particules électriquement conductrices 4 et d'éléments de forme allongée 6 solidarisés par du matériau électriquement conducteur 5 (figure 5). En fait, le matériau électriquement conducteur forme au moins une brasure assemblant/fixant les particules et les éléments de forme allongée de l'assemblage (figure 5). Selon une autre formulation, au terme de l'étape de refroidissement E3, ou de l'étape de refroidissement additionnelle E7, l'organe électriquement conducteur 2 comporte au moins un chemin électriquement conducteur comprenant au moins plusieurs des particules électriquement conductrices 4 et au moins plusieurs des éléments de forme allongée 6. Au moins une partie du matériau électriquement conducteur 5 assure alors le lien mécanique, et notamment électrique, entre les particules électriquement conductrices 4 du chemin et les éléments de forme allongée 6 du chemin. On comprend que le matériau électriquement conducteur 5 a subi une fusion lui permettant d'assurer la connexion électrique et mécanique souhaitée entre les particules électriquement conductrices 4 du chemin et les éléments de forme allongée 6 du chemin. Notamment, les particules électriquement conductrices 4 dudit chemin sont reliées chacune à au moins un des éléments de forme allongée 6 du chemin par une portion du matériau électriquement conducteur, c'est-à-dire par un élément de liaison 7 correspondant comportant au moins une portion du matériau électriquement conducteur 5. Par ailleurs, chaque élément de forme allongée 6 dudit chemin peut être relié à au moins un autre des éléments de forme allongée 6 dudit chemin par une portion correspondante du matériau électriquement conducteur, c'est-à-dire par un organe de liaison 7a (figure 5) correspondant comportant au moins une portion du matériau électriquement conducteur 5. Les organes de liaison et les éléments de liaison peuvent être formés au sein d'une continuité de matière en matériau électriquement conducteur. La conductivité électrique globale de l'organe électriquement conducteur 2 est donnée par le chemin électriquement conducteur ou une pluralité de chemins électriquement conducteurs reliés électriquement entre eux. Dans l'idéal, chaque particule électriquement conductrice 4 de l'organe électriquement conducteur 2 appartient à un chemin électriquement conducteur, et est reliée à au moins un des éléments de forme allongée 6 par un élément de liaison 7 tel que décrit. Dans l'idéal, chaque particule électriquement conductrice 4 est reliée électriquement à chacune des autres particules 4 électriquement conductrices. Notamment, l'organe électriquement conducteur s'étend entre deux extrémités (par exemple longitudinales), et le ou les chemins électriquement conducteurs permettent d'assurer une conductivité électrique entre ces deux extrémités. Dans le présent paragraphe, ce qui a été dit en relation avec le chemin peut s'appliquer à l'assemblage. Bien que ce qui a été dit dans le présent paragraphe soit donné en relation avec le procédé d'utilisation, cela peut aussi s'appliquer dans le cadre du dispositif thermoformé pris isolément ou dans le cadre du dispositif destiné à être thermoformé pris isolément, notamment du moment que le matériau électriquement conducteur a subi au préalable une fusion.

On comprend de ce qui a été dit ci-dessus que de manière générale, le procédé d'utilisation peut comporter une étape de fusion du matériau électriquement conducteur 5, cette étape de fusion pouvant être réalisée par l'étape de chauffe E1 ou l'étape de chauffe additionnelle E6. Consécutivement à l'étape de fusion, une étape de solidification (par exemple réalisée par l'étape de refroidissement ou l'étape de refroidissement additionnelle) du matériau électriquement conducteur permet de former l'organe électriquement conducteur tel que décrit dans le paragraphe précédent, et comportant notamment l'assemblage décrit.

Un élément de liaison 7 au sens de la présente description peut permettre de relier mécaniquement et électriquement au moins une particule 4 à au moins un élément de forme allongée 6 : il y a contact entre l'élément de liaison 7 et la particule 4 et entre l'élément de liaison 7 et l'élément de forme allongée 6. Un organe de liaison 7a au sens de la présente description peut permettre de relier mécaniquement et électriquement des éléments de forme allongée 6 entre eux : il y a contact entre les éléments de forme allongée et l'organe de liaison. Par ailleurs, au terme de l'étape de refroidissement (additionnelle ou non) ou dans le cadre du dispositif thermoformé, l'organe électriquement conducteur 2 peut être tel qu'un même élément de forme allongée peut être relié à plusieurs particules électriquement conductrices par des éléments de liaison correspondants.

Le procédé d'utilisation peut comporter (figure 4) une étape de fourniture E0 du dispositif destiné à être thermoformé tel que décrit en amont de l'étape E1 de chauffe, c'est à dire avant la phase de thermoformage.

Au cours de la phase de thermoformage Ph1, notamment au cours des étapes de chauffe E1 et de mise en forme E2, l'élément électriquement conducteur 2 reste solidaire du substrat 3. En ce sens, la phase de thermoformage permet aussi de modifier la forme de l'organe électriquement conducteur 2. La déformation de l'organe électriquement conducteur 2 est, de préférence, accompagnée par la fonte du matériau électriquement conducteur 5 qui vient, après refroidissement, connecter électriquement des particules de l'organe électriquement conducteur 2 avec des éléments de forme allongée 6 de l'organe électriquement conducteur 2.

Comme illustré en figure 5, l'invention est aussi relative à un dispositif thermoformé comportant le substrat 3, dont la forme a été obtenue par thermoformage, et l'organe électriquement conducteur 2 solidaire du substrat 3. L'organe électriquement conducteur 2 comporte les particules électriquement conductrices 4, le matériau électriquement conducteur 5 (notamment ayant subi une fusion) et les éléments de forme allongée 6 électriquement conducteurs. De préférence, l'organe électriquement conducteur 2 est tel qu'au moins une des particules électriquement conductrices 4 est reliée à au moins un des éléments de forme allongée 6 par un élément de liaison 7 comportant au moins une portion du matériau électriquement conducteur 5 en particulier obtenue par fusion, puis solidification du matériau électriquement conducteur 5. En particulier, l'organe électriquement conducteur 2 peut être tel qu'il comporte l'assemblage décrit précédemment, ou au moins un chemin électriquement conducteur tel que décrit précédemment. Par exemple, au moins une partie des particules 4 sont unies à des éléments de forme allongée 6 par fusion du matériau électriquement conducteur 5. Selon une autre formulation, l'organe électriquement conducteur 2 peut comporter au moins un élément de liaison 7 (notamment des éléments de liaison) comportant au moins une portion du matériau électriquement conducteur 5, en particulier cette portion a été obtenue par fusion puis par solidification du matériau électriquement conducteur 5, chaque élément de liaison 7 reliant au moins une des particules électriquement conductrices 4 à au moins l'un des éléments de forme allongée 6. Bien entendu, le matériau électriquement conducteur 5 présente une température de fusion strictement inférieure à la température de fusion des particules électriquement conductrices 4 et à la température de fusion des éléments de forme allongée 6. Par ailleurs, l'organe électriquement conducteur 2 peut aussi comporter des organes de liaison 7a comportant au moins une portion du matériau électriquement conducteur 5 et reliant chacun au moins un des éléments de forme allongée 6 à au moins un autre des éléments de forme allongée.

De manière générale, applicable au procédé d'utilisation, au dispositif destiné à être thermoformé et au dispositif thermoformé, les éléments de liaison 7 et le cas échéant les organes de liaison 7a ont été obtenus par fusion du matériau électriquement conducteur 5 puis par solidification de ce dernier. Les éléments et organes de liaison peuvent chacun former un joint de brasure ou un joint brasé. Une liaison obtenue par fusion puis par solidification du matériau électriquement conducteur 5 peut facilement être identifiée, en effet elle est assimilable à un joint de brasure dans le sens où le matériau électriquement conducteur présent au sein de la liaison permet de former une liaison intermétallique entre au moins une des particules électriquement conductrices 4 et au moins un des éléments de forme allongée 6. En fait, le matériau électriquement conducteur 5 en fusion pénètre par capillarité ou par diffusion dans des pores situés en surface de l'élément de forme allongée 6 et de la particule électriquement conductrice 4. Le même principe s'applique pour l'organe de liaison 7a qui relie des éléments de forme allongée entre eux. On comprend que l'assemblage décrit ci-avant est notamment tel que les particules et les éléments de forme allongée sont brasés entre eux par du matériau électriquement conducteur 5.

On comprend que le matériau électriquement conducteur 5 permet par exemple de former des soudures, chaque soudure reliant au moins une particule électriquement conductrice à au moins un élément de forme allongée. Dans la présente description, on entend par « soudure » la définition au sens large de ce terme, à savoir la formation d'une liaison entre deux pièces (cette liaison permettant notamment d'assurer un maintien mécanique et une continuité électrique entre les deux pièces) sans préjuger de la technique utilisée pour obtenir cette liaison. De préférence, le terme soudure est interprété comme étant une brasure qui correspond à la formation d'une liaison obtenue par fonte d'un matériau d'apport formé par du matériau électriquement conducteur 5 sans que les contours primitifs des particules électriquement conductrices 4 et des éléments de forme allongée 6 aient été modifiés par le brasage.

Autrement dit, au cours de l'étape de chauffe E1, ou de l'étape de chauffe additionnelle E6 (et notamment tout au long du procédé d'utilisation) du dispositif (ou plus généralement au cours de l'étape de fusion du matériau électriquement conducteur 5 décrite ci-avant), les particules électriquement conductrices 4 et les éléments de forme allongée 6 conservent leurs contours primitifs. On entend par là que les éléments de forme allongée et les particules électriquement conductrices 4 restent à l'état solide. Ainsi, l'étape de chauffe E1, ou l'étape de chauffe additionnelle E6, ou le cas échéant l'étape de fusion du matériau électriquement conducteur 5, est telle que les particules électriquement conductrices 4 restent en dessous de leur température de fusion et que les éléments de forme allongée 6 restent en dessous de leur température de fusion.

Selon une réalisation du dispositif destiné à être thermoformé, l'organe électriquement conducteur comporte au moins un élément de liaison 7 (figure 6) comportant au moins une portion du matériau électriquement conducteur 5, notamment obtenue par fusion puis solidification du matériau électriquement conducteur 5. Chaque élément de liaison 7 relie un moins une des particules électriquement conductrices 4 à au moins un des éléments de forme allongée 6. La fusion du matériau électriquement conducteur 5 a, par exemple, été obtenue lors de l'évaporation, mise en œuvre par traitement thermique, d'un solvant d'une encre utilisée pour former l'organe électriquement conducteur sur le substrat 3. En particulier, selon cette réalisation, l'organe électriquement conducteur peut comporter un assemblage ou au moins un chemin électriquement conducteur tel que décrit précédemment. Cette réalisation présente l'avantage d'avoir des brasures avant le thermoformage ce qui peut être préféré lorsque les contraintes mécaniques et les formes à épouser du moule lors du thermoformage sont très contraignantes.

La figure 7 illustre un mode de réalisation particulier du dispositif destiné à être thermoformé pour lequel l'organe électriquement conducteur 2 comporte un empilement de couches comportant une première couche 8 et une deuxième couche 9 agencée sur la première couche 8. La première couche 8 est interposée entre le substrat 3 et la deuxième couche 9. Notamment, la première couche 8 est agencée sur le, c'est à dire assemblée au, substrat 3. La première couche 8 comporte une partie des éléments de forme allongée. En particulier, la première couche 8 est une couche d'éléments de forme allongée, qui peut éventuellement comporter un liant. La deuxième couche 9 comporte une autre partie (ou le reste) des éléments de forme allongée, les particules électriquement conductrices et le matériau électriquement conducteur. En particulier, la deuxième couche 9 est une couche de particules électriquement conductrices au sein de laquelle le matériau électriquement conducteur et les éléments de forme allongée sont dispersés : cette deuxième couche 9 comporte donc majoritairement des particules. Cette réalisation est préférée car, lors du thermoformage, la première couche 8 permet de former un rail de guidage sur lequel glisse les particules électriquement conductrices, le matériau électriquement conducteur (ce matériau électriquement conducteur étant à l'état liquide ou solide au cours du thermoformage : si l'état du matériau électriquement conducteur est solide l'organe électriquement conducteur est tel que des particules électriquement conductrices sont libres de bouger ou de se déplacer sous sollicitations mécaniques) et les éléments de forme allongée 6 de la deuxième couche 9. Cette réalisation présente le plus grand intérêt car la présence d'une couche intermédiaire d'éléments de forme allongée entre le substrat et le reste de l'empilement permet de limiter la perte de conductivité de l'organe électriquement conducteur jusqu'à des allongements de 60% du substrat et même sous sollicitation thermique à très haute température. Cette option a permis de surmonter des difficultés tant mécanique que thermique lors de déformations et de recuits. Par ailleurs, cette réalisation donne un système le plus stable : il n'y a quasiment pas d'apparition de fissures lors des étirements en température, et la structure s'étire sans trop se déformer comme si elle se dépliait de l'intérieur. Au cours du thermoformage, les première et deuxième couches 8, 9 peuvent se mélanger en partie en cas de fonte du matériau électriquement conducteur, ou se mélanger en partie à travers les interstices des couches. Par exemple, le matériau électriquement conducteur peut migrer de sorte à lier, notamment par brasage pour lequel le matériau électriquement conducteur forme un matériau d'apport, des éléments de forme allongés entre eux (qu'ils proviennent de la première couche 8 ou de la deuxième couche 9) et avec des particules électriquement conductrices correspondantes. La première couche 8 peut présenter une épaisseur comprise entre 100nm et 2µm, les éléments de forme allongée présents dans la première couche 8 peuvent représenter entre 35% et 85% du volume de la première couche 8. La deuxième couche 9 peut présenter une épaisseur comprise entre 5µm et 25µm, les éléments de forme allongée présents dans la deuxième couche 9 peuvent représenter entre 5% et 35% du volume de la deuxième couche 9. Les particules électriquement conductrices dans la deuxième couche peuvent représenter entre 55% et 80% du volume de la deuxième couche et le matériau électriquement conducteur peut représenter entre 10% et 30% du volume de la deuxième couche 9. En particulier, l'épaisseur des différentes couches peut varier en fonction de la conductivité électrique globale recherchée de l'organe électriquement conducteur, le but étant généralement d'obtenir une conductivité électrique supérieure à 10⁶S/m pour l'organe électriquement conducteur dans sa globalité.

Selon une variante de la réalisation de la figure 7, l'organe électriquement conducteur 2 comporte un empilement de couches comportant une première couche 8 et une deuxième couche 9 agencée sur la première couche 8. La première couche est interposée entre le substrat 3 et la deuxième couche 9. La première couche 8 comporte les éléments de forme allongée et la deuxième couche 9 comporte les particules électriquement conductrices et de préférence le matériau électriquement conducteur. De préférence, selon cette variante la première couche 8 comportant les éléments de forme allongée relie le substrat 3 à la deuxième couche 9 comportant les particules électriquement conductrices. Ici, le matériau électriquement conducteur peut être présent dans la deuxième couche 9 comportant les particules électriquement conductrices et/ou dans la première couche 8 comportant les éléments de forme allongée. Selon cette variante, l'épaisseur de la deuxième couche 9 peut être comprise entre 5µm et 25µm, de préférence égale à 15µm. Notamment, les particules électriquement conductrices peuvent représenter entre 55% et 85% du volume de la deuxième couche 9, et, le cas échéant le matériau électriquement conducteur présent dans la deuxième couche peut représenter entre 10% et 30% du volume de la deuxième couche 9. La première couche 8 comportant les éléments de forme allongée peut présenter une épaisseur comprise entre 50nm et 2µm, notamment les éléments de forme allongée peuvent représenter plus de 65%, préférentiellement plus de 80%, du volume de la première couche 8. Ici, lors du thermoformage les constituants des première et deuxième couches 8, 9 peuvent se mélanger avec ou sans fonte du matériau électriquement conducteur. Dans le cas où il y a un mélange sans fonte du matériau électriquement conducteur, les particules électriquement conductrices sont préférentiellement individuelles, et elles peuvent bouger, par exemple sous sollicitation mécanique, et donc se déplacer (dans ce cas si il y a des éléments de forme allongée il pourra y avoir un point de contact entre une particule s'étant déplacée et un élément de forme allongée) au niveau de l'interface entre les couches 8 et 9, par exemple pour former au moins un chemin électriquement conducteur tel que décrit ci-avant.

Selon une autre réalisation du dispositif destiné à être thermoformé illustrée en figure 8, l'organe électriquement conducteur 2 comporte un empilement de couches comprenant une couche 10 comportant les particules électriquement conductrices (notamment une couche 10 de particules électriquement conductrices), une couche 11 comportant le matériau électriquement conducteur (notamment une couche 11 en matériau électriquement conducteur), et une couche 12 comportant les éléments de forme allongée (notamment une couche 12 d'éléments de forme allongée). De préférence, la couche 11 comportant le matériau électriquement conducteur est interposée entre la couche 10 comportant les particules et la couche 12 comportant les éléments de forme allongée : ceci permet de faciliter, en particulier lors de la fusion du matériau électriquement conducteur notamment lors de la phase de thermoformage ou ultérieurement, la création d'éléments de liaison, formant notamment des joints de brasure, reliant chacun au moins une des particules avec au moins un des éléments de forme allongée. La couche 11 comportant le matériau électriquement conducteur est notamment en contact avec la couche 10 comportant les particules et la couche 12 comportant les éléments de forme allongée. Notamment, la couche 12 comportant les éléments de forme allongée est interposée entre le substrat 3 et la couche 11 comportant le matériau électriquement conducteur (cette couche 12 est notamment en contact avec le substrat 3) : le fait de positionner les éléments de forme allongée à l'interface avec le substrat 3 permet d'améliorer le comportement à l'étirement de l'organe électriquement conducteur 2 puisque les particules électriquement conductrices vont glisser et se répartir plus facilement dans l'organe électriquement conducteur 2 lorsque le matériau électriquement conducteur se trouve à l'état liquide ou solide. Le cas échéant, si le matériau électriquement conducteur ne fond pas lors du thermoformage, des particules électriquement conductrices libres et individuelles peuvent par exemple changer de point de contact avec un élément de forme allongée et finalement toujours être en contact électrique avec ce dernier après un déplacement provoqué par une sollicitation thermique ou mécanique par exemple appliquée au substrat. En outre, la couche 12 comportant les éléments de forme allongée est celle qui présente le meilleur comportement à l'étirement du fait de la présence des éléments de forme allongée qui vont s'orienter selon l'étirement du substrat au cours du thermoformage. La couche 12 comportant les éléments de forme allongée peut présenter une épaisseur maximale de 2µm, et notamment comprise entre 100nm et 500nm, et les éléments de forme allongée peuvent représenter entre 35% et 85 % en volume de la couche 12. La couche 11 peut présenter une épaisseur comprise entre 100nm et 2µm, et le matériau électriquement conducteur peut représenter entre 35% et 85 % en volume de la couche 11. La couche 10 peut présenter une épaisseur comprise entre 2 µm et 20 µm, et les particules électriquement conductrices peuvent représenter entre 65% et 85 % en volume de la couche 10. Ici les constituant des trois couches 10, 11, 12 vont pouvoir se mélanger au moins en partie, notamment au cours du thermoformage avec ou sans fusion du matériau électriquement conducteur, par exemple par diffusion du matériau électriquement conducteur et migration des particules électriquement conductrices en direction des éléments de forme allongée.

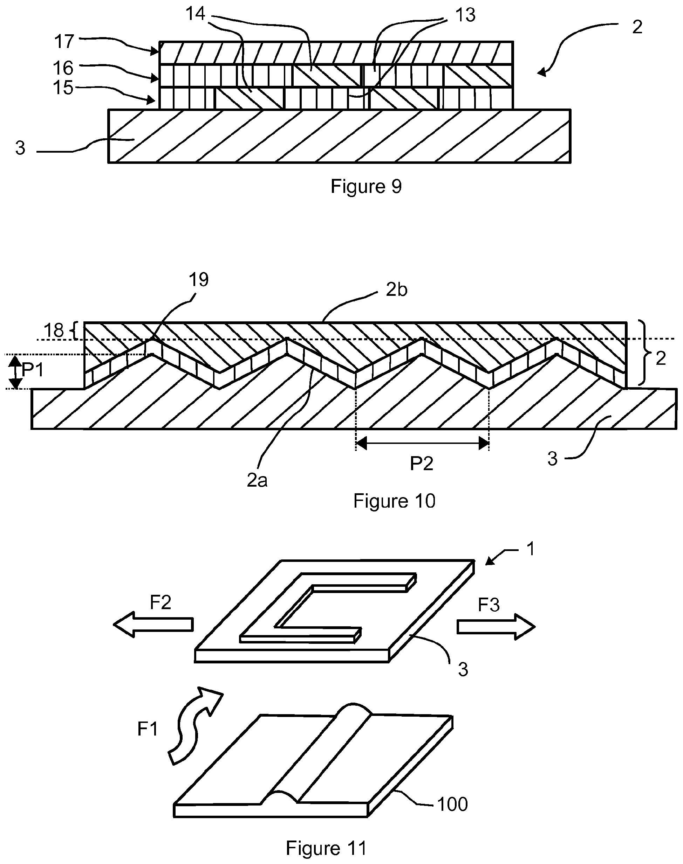

Selon encore une autre réalisation du dispositif destiné à être thermoformé illustrée en figure 9, l'organe électriquement conducteur 2 comporte des premières parties 13 comportant chacune une partie correspondante des particules électriquement conductrices, et des deuxièmes parties 14 comportant chacune une partie correspondante des éléments de forme allongée. En particulier, le matériau électriquement conducteur est présent dans les premières parties 13 et/ou dans les deuxièmes parties 14. De préférence, ici l'organe électriquement conducteur 2 comporte un empilement de couches comportant une première couche 15, notamment agencée sur le substrat 3, munie d'au moins une des premières parties 13 et d'au moins une des deuxièmes parties 14, une deuxième couche 16 agencée sur la première couche 15 et munie d'au moins une des premières parties 13 et d'au moins une des deuxièmes parties 14. Ici, chaque deuxième partie 14 est à distance des autres deuxièmes parties 14 : il n'y a donc pas de contact entre les deuxièmes parties 14 de sorte à favoriser un mélange entre les parties 13 et 14 lors de la fonte du matériau électriquement conducteur, mais les deuxièmes parties 14 sont chacune en contact avec au moins une première partie 13. Autrement dit, cette réalisation permet de former des îlots comportant chacun une partie correspondante des éléments de forme allongée, ces îlots étant reliés entre eux par de la matière comportant les particules électriquement conductrices et éventuellement du matériau électriquement conducteur. Ce cas permet d'avoir localement dans l'organe électriquement conducteur des zones/parties à forte déformations susceptibles d'emmagasiner la plupart des efforts lors du thermoformage (avec ou sans fonte du matériau électriquement conducteur lors du thermoformage, si il n'y a pas de fonte du matériau électriquement conducteur alors l'organe peut être tel que des particules 4 sont capables de bouger lors du thermoformage), et d'obtenir au final un organe électriquement conducteur : on comprend alors que les deuxièmes parties seront préférentiellement judicieusement agencées en tenant compte du futur étirement du substrat 3 et donc de l'organe électriquement conducteur 2 au cours du thermoformage. Autrement dit, la position, les dimensions et la composition des premières et deuxièmes parties 13, 14 peuvent être ajustées en fonction de la forme que l'on souhaite donner au dispositif thermoformable. En effet, la présence d'éléments de forme allongée présentant une longueur supérieure aux dimensions maximales des particules électriquement conductrices permettra aux parties comportant les éléments de forme allongée d'avoir un meilleur comportement à l'étirement. De plus, il est possible que les parties comprenant les éléments de forme allongée présentent des dimensions différentes et/ou des densités en éléments de forme allongée différentes pour tenir compte du futur étirement local du substrat 3, et donc de l'organe électriquement conducteur 2 au cours du thermoformage. En particulier, l'empilement comporte aussi une troisième couche 17 agencée sur la deuxième couche 16 de l'empilement, cette troisième couche comportant des particules électriquement conductrices réparties dans toute la troisième couche, et de préférence du matériau électriquement conducteur. Ici, la hauteur de l'empilement peut par exemple être de 20µm, et il peut présenter une largeur comprise entre 50µm et 2mm. La première couche 15 peut présenter une épaisseur comprise entre 100nm et 2µm, la deuxième couche 16 peut présenter une épaisseur comprise entre 2µm et 5µm, et la troisième couche 17 peut présenter une épaisseur comprise entre 8µm et 18µm. Les éléments de forme allongée peuvent représenter entre 35% et 85% en volume de chacune des deuxièmes parties. Par ailleurs, le cas échéant, le matériau électriquement conducteur présent dans les deuxièmes parties peut représenter entre 10% et 55 % du volume de chacune des deuxièmes parties. Les particules électriquement conductrices peuvent représenter entre 35% et 85% en volume de chacune des premières parties. Par ailleurs, le cas échéant, le matériau électriquement conducteur présent dans les premières parties peut représenter entre 65% et 85 % du volume de chacune des premières parties ou s'adapter au volume des particules électriquement conductrices des premières parties. Les particules électriquement conductrices peuvent représenter entre 65% et 85% en volume de la troisième couche 17, le cas échéant le matériau électriquement conducteur présent dans la troisième couche 17 représente entre 15% et 35 % du volume de la troisième couche 17. Lors du thermoformage, notamment avec fusion du matériau électriquement conducteur, les différentes couches vont coopérer et se mélanger au moins partiellement pour former un assemblage ou au moins un chemin électriquement conducteur tel que décrits précédemment.

De manière générale, un pourcentage du volume, pour chaque couche ou chaque partie, peut aussi comporter un liant qui sera décrit plus en détails ci-après. L'homme du métier saura adapter les couches (ou les premières et deuxièmes parties) pour arriver au résultat escompté, par exemple lorsque dans les exemples donnés les choses présentes dans le volume d'une couche n'atteignent pas les 100% du volume de cette couche, l'homme du métier peut former cette couche de telle sorte qu'elle comporte des particules électriquement conductrices additionnelles, par exemple du type des particules électriquement conductrices 4 telles que décrites pour tendre vers, ou atteindre, ce volume de 100%. Par ailleurs, si nécessaire, l'homme du métier pourra adapter les gammes données en pourcentage pour atteindre, ou tendre vers, le volume de 100%. L'organe électriquement conducteur peut aussi comporter, pour un volume de 100% comportant les particules 4, les éléments de forme allongé 6 et le matériau électriquement conducteur 5, 80% de particules 4, 10% d'éléments de forme allongée 6 et 10% de matériau électriquement conducteur 5.

Par ailleurs, on comprend de ce qui a été dit précédemment que lorsque le matériau électriquement conducteur ne fond pas lors du thermoformage (c'est-à-dire lors de la phase ph1 de thermoformage), l'organe électriquement conducteur est notamment tel que des particules électriquement conductrices 4 sont capables de se déplacer.

De manière applicable à tous les modes de réalisation, l'épaisseur de l'organe électriquement conducteur 2 du dispositif destiné à être thermoformé selon une direction normale au substrat peut être fonction de son épaisseur désirée après thermoformage du dispositif tout en connaissant les caractéristiques d'étirement du substrat 3, et donc de l'organe électriquement conducteur, lors du thermoformage.

Dans le cadre d'un organe électriquement conducteur 2 formant une piste électriquement conductrice, la largeur de la piste avant thermoformage est préférentiellement comprise entre 50µm et 2mm, et la hauteur de la piste peut être comprise entre 1µm et 35µm, et notamment égale à 20µm. La longueur de la piste sera adaptée à ce que l'on souhaite réaliser. Après thermoformage, la largeur de la piste est préférentiellement comprise entre 50µm et 5mm, et la hauteur de la piste peut être comprise entre 5µm et 25µm, et notamment égale à 15µm. Les dimensions données ici après thermoformage peuvent prendre en compte un élargissement ou un retrait de l'organe électriquement conducteur du fait de la mise en forme du substrat qui le porte.

De préférence, au sein de l'organe électriquement conducteur 2 (figures 2 et 5) on retrouve en pourcentage en poids, et de manière décroissante de ce pourcentage en poids, les particules électriquement conductrices 4, les éléments de forme allongée 6, puis le matériau électriquement conducteur 5. Typiquement, un minimum de 60% en poids, et plus particulièrement 80% en poids, ou selon une gamme entre 65% et 85% en poids, de l'organe électriquement conducteur 2 correspond au poids des particules électriquement conductrices 4. Le pourcentage restants en poids de l'organe électriquement conducteur correspond au poids des éléments de forme allongée 6, du matériau électriquement conducteur 5 et d'un éventuel liant utilisé pour former une encre à déposer en vue de réaliser l'organe électriquement conducteur. Plus particulièrement, pour le pourcentage en poids restant, les éléments de forme allongée 6 représentent en poids deux fois plus que le poids du matériau électriquement conducteur 5, et le liant lorsqu'il est présent représente en poids la moitié du poids du matériau électriquement conducteur 5. L'homme du métier est à même d'adapter les proportions des constituants de l'organe électriquement conducteur en fonction du résultat recherché après thermoformage.

De manière générale applicable à toutes les réalisations du dispositif destiné à être thermoformé, le substrat 3 peut présenter, à son interface avec l'organe électriquement conducteur 2, une structuration en creux (figure 10). Dans ce cas, l'organe électriquement conducteur 2 s'étend depuis la structuration en creux et comporte une tranche 18 s'étendant depuis les sommets 19 des creux et présentant une épaisseur comprise entre 100nm et 20µm. La présence de cette tranche 18 permet d'assurer une continuité de l'organe électriquement conducteur 2 avant et après thermoformage du dispositif. Selon une autre formulation, on dit que l'organe électriquement conducteur 2 du dispositif destiné à être thermoformé comporte une première face 2a en contact avec le substrat 3 et une deuxième face 2b opposée à la première face 2a, la surface de la première face 2a est strictement supérieure à la surface de la deuxième face 2b. La présence des creux est avantageuse dans le sens où, lors du thermoformage, le substrat 3 va subir des contraintes en étirement globalement plus importantes que celles de l'organe électriquement conducteur : il en résulte que l'étirement de l'organe électriquement conducteur est limité, limitant ainsi l'apparition de fissures dans ce dernier. En particulier, les creux présentent une profondeur P1 comprise entre 50nm et 50µm, et notamment égale à 20µm, par ailleurs le pas P2 de répétition des creux est compris entre 100µm et 2mm. Le pas P2 entre deux creux représente généralement la distance la plus courte séparant le centre du fond de deux creux adjacents. La figure 10 illustre la réalisation du substrat 3 en creux combiné au mode de la figure 7, bien entendu le substrat en creux peut s'appliquer à tous les autres modes de réalisation.

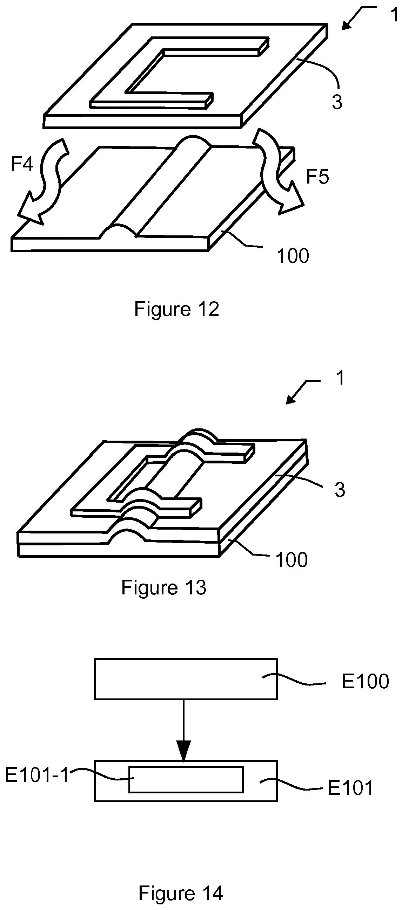

Pour en revenir au procédé d'utilisation, ce dernier peut comporter une étape E4, comme représenté en figure 4, de fourniture d'un objet 100 (figure 11) comportant la forme prédéterminée (par exemple un moule) c'est-à-dire permettant de donner au dispositif la forme prédéterminée, et l'étape de mise en forme E2 comporte successivement une étape de projection E2-1 d'un fluide gazeux (flèche F1) de sorte à étirer (flèches F2 et F3) le substrat 3 du dispositif chauffé, et une étape d'aspiration E2-2 (flèches F4, F5 de la figure 12) permettant de plaquer le dispositif 1 (notamment le substrat 3 du dispositif 1) contre l'objet 100 (figure 13) de sorte que ledit dispositif 1 (notamment le substrat 3) épouse au moins une partie de la surface dudit objet 100.

De manière générale, l'organe électriquement conducteur 2, que cela soit dans le cadre du dispositif destiné à être thermoformé, c'est-à-dire avant son thermoformage, ou du dispositif thermoformé, peut comporter de la cellulose, ou un élastomère en caoutchouc ou en silicone formant le liant évoqué ci-dessus. La cellulose ou l'élastomère peut se présenter sous la forme de fibres, appelées nanofibres, et a servi de liant pour former l'organe électriquement conducteur lorsque ce dernier a été imprimé avec une encre dont la viscosité a été adaptée par ledit liant.

L'invention est aussi relative à un procédé de fabrication d'un dispositif destiné à être thermoformé tel que décrit. On est ici dans le domaine de l'électronique imprimée. Ce procédé de fabrication comporte (figure 14) :
- une étape de fourniture E100 du substrat 3 (figure 1),
- une étape de formation E101 de l'organe électriquement conducteur 2 mettant en œuvre au moins une étape de dépôt E101-1 d'une encre sur le substrat 3 (figure 1).

L'étape de dépôt de l'encre sur le substrat peut être mise en œuvre par sérigraphie, par jet d'encre, par héliogravure ou par enduction. Le dépôt d'une encre est aussi appelé impression de l'encre dans le domaine. Par ailleurs, tout autre type de dépôt peut être mis en œuvre du moment qu'il permet d'obtenir le résultat recherché.

De manière générale, au sens de la présente description, une encre comporte un solvant, le cas échéant les particules électriquement conductrices et/ou les éléments de forme allongée et/ou le matériau électriquement conducteur. Le solvant permet de mouiller et fluidifier l'encre pour autoriser son dépôt/impression. Le solvant peut être choisi parmi l'Ethylène glycol, le mono éther éthylène glycol, l'Isopropanol, le cyclopetanone, l'éthanol, le toluène, le mésitylène, et le Méthyle acétate. Le solvant présente une tension de vapeur très basse à température ambiante de 35°C, la tension de vapeur est liée à la tendance des molécules à passer de l'état liquide (ou solide) à l'état gazeux. Idéalement, le solvant est aussi notamment choisi pour pouvoir s'évaporer en un temps raisonnable, par exemple de l'ordre de 5min, à une température prédéterminée, par exemple de 150°C, pour minimiser le temps de séchage sur le substrat. Selon les cas, on comprend que l'évaporation du solvant est susceptible de faire fondre le matériau électriquement conducteur mais pas les particules électriquement conductrices ni les éléments de forme allongée.

Selon un exemple particulier, permettant notamment de mettre en œuvre la réalisation de la figure 2, le procédé de fabrication peut comporter une étape de préparation de l'encre de telle sorte qu'elle comporte le solvant, les particules électriquement conductrices, le matériau électriquement conducteur et les éléments de forme allongée. L'étape de dépôt permet ensuite de déposer une couche selon un motif adapté, puis le solvant est évaporé par exemple par la mise en œuvre d'une étape de traitement thermique après l'étape de dépôt.

Selon un autre exemple particulier permettant de mettre en œuvre la réalisation de la figure 7, le procédé de fabrication peut comporter une étape de préparation d'une première encre et d'une deuxième encre, la première encre étant déposée sur le substrat et la deuxième encre étant déposée sur la première encre après évaporation du solvant de la première encre. Ici la première encre peut comporter le solvant et tout ce que comporte la couche 8 évoquée précédemment, et la deuxième encre peut comporter le solvant et tout ce que comporte la couche 9 évoquée précédemment. Après dépôt de la deuxième encre, le solvant de la deuxième encre est évaporé.

Selon un autre exemple particulier permettant de mettre en œuvre la réalisation de la figure 8, le procédé de fabrication peut comporter une étape de préparation d'une première encre, d'une deuxième encre et d'une troisième encre, la première encre étant déposée sur le substrat et la deuxième encre étant déposée sur la première encre après évaporation du solvant de la première encre, et la troisième encre étant déposée sur la deuxième encre après évaporation du solvant de la deuxième encre, puis le solvant de la troisième encre est évaporé. Ici la première encre peut comporter le solvant et tout ce que comporte la couche 12 évoquée précédemment, la deuxième encre peut comporter le solvant et tout ce que comporte la couche 11 évoquée précédemment, et la troisième encre peut comporter le solvant et tout ce que comporte la couche 10 évoquée précédemment.

Concernant le mode de réalisation de la figure 9, le procédé de fabrication peut comporter une étape de préparation d'une première encre et d'une deuxième encre qui seront déposées de sorte à obtenir le résultat recherché

De manière applicable à chaque encre décrite ci-avant, ladite encre peut aussi comporter des agents dispersants qui s'opposent à l'agglomération/à la sédimentation de son ou ses constituants comme le cas échéant les particules électriquement conductrices et/ou le matériau électriquement conducteur et/ou des éléments de forme allongée. Par ailleurs, comme il l'a été évoqué précédemment, l'encre peut comporter un liant comportant de la cellulose et/ou un élastomère en caoutchouc ou en silicone. Le rôle de ce liant est d'adapter la viscosité de l'encre pour que cette dernière soit compatible avec la technique d'impression utilisée.

Selon une réalisation particulière qui peut s'appliquer à tout ce qui a été dit précédemment, il est connu à l'avance la forme prédéterminée que l'on souhaite donner au dispositif lors du thermoformage. En ce sens, il est possible de connaître localement à l'organe électriquement conducteur la contrainte à laquelle il sera soumis lors du thermoformage et d'adapter en conséquence sa composition. En ce sens, l'organe électriquement conducteur peut comporter plusieurs parties ou tronçons comportant chacun des particules électriquement conductrices 4, un matériau électriquement conducteur 5, des éléments de forme allongée 6 électriquement conducteurs. Pour chaque partie, la quantité de particules électriquement conductrices 4 et/ou du matériau électriquement conducteur 5, et/ou des éléments de forme allongée 6 électriquement conducteurs peut être adaptée en fonction d'un paramètre d'étirement connu à l'avance. Par ailleurs, la dimension en longueur des éléments de forme allongée peut être adaptée en fonction de l'étirement prévu du substrat au cours du thermoformage

Il résulte de tout ce qui a été dit ci-avant que le dispositif destiné à être thermoformé est tout particulièrement adapté pour former des organes électriquement conducteurs après thermoformage qui présentent une conductivité adaptée à leur application comme dans le domaine des antennes.

Par ailleurs, le dispositif décrit peut être élargi à tout dispositif déformable, c'est à dire dont le substrat est déformable, par exemple par étirement mécanique, ou par thermoformage. En effet, la présence d'éléments de forme allongée dans l'organe électriquement conducteur peut permettre d'encaisser des allongements provoqués par des étirements.

Ainsi, le dispositif peut subir une déformation de son substrat selon une ou plusieurs directions. Par ailleurs, l'organe électriquement conducteur est tel qu'il est aussi capable d'absorber des efforts sans rompre du fait de sa structure même dans des applications où il y a un étirement permanent ou ponctuel. La ou les encres décrites ci-dessus peuvent aussi être utilisées sur des substrats qui auront vocation à se déformer pendant leur application. La composition de l'organe électriquement conducteur lui permet de subir des contraintes tout en assurant sa fonction.

La présente invention permet d'améliorer la conductivité électrique d'un organe électriquement conducteur déformé grâce aux éléments de forme allongée qui peuvent plus facilement s'étendre entre des particules électriquement conductrices s'étant éloignées du fait d'un thermoformage, ou d'une déformation, en vue de participer à leur connexion électrique ultérieurement à la fonte du matériau électriquement conducteur. Plus l'étirement du substrat est important, notamment lors du thermoformage, plus l'organe électriquement conducteur sera mis sous contrainte, et plus les éléments de forme allongée auront une longueur importante pour permettre d'assurer une bonne conductivité électrique après étirement.

## Revendications

1. Dispositif (1) destiné à être thermoformé comportant un substrat (3) apte à être thermoformé et un organe électriquement conducteur (2) solidaire dudit substrat (3), l'organe électriquement conducteur (2) comportant :
- des particules électriquement conductrices (4),
- des éléments de forme allongée (6) électriquement conducteurs,
**caractérisé en ce que** l'organe électriquement conducteur (2) comporte, en outre, un matériau électriquement conducteur (5) présentant une température de fusion strictement inférieure à la température de fusion des particules électriquement conductrices (4) et à la température de fusion des éléments de forme allongée (6).

2. Dispositif selon la revendication 1, **caractérisé en ce que** les éléments de forme allongée (6) ont une longueur supérieure ou égale à 20µm, et/ou **en ce que** au moins l'un des éléments de forme allongée (6) adopte une configuration repliée.

3. Dispositif selon l'une quelconque des revendications précédentes, **caractérisé en ce que** l'organe électriquement conducteur (2) comporte au moins un élément de liaison (7) comportant au moins une portion du matériau électriquement conducteur (5), obtenue par fusion puis solidification du matériau électriquement conducteur (5), chaque élément de liaison (7) reliant au moins une des particules électriquement conductrices (4) à au moins un des éléments de forme allongée (6).

4. Dispositif selon l'une quelconque des revendications 1 à 2, **caractérisé en ce que** l'organe électriquement conducteur (2) comporte un empilement de couches comportant une première couche (8) et une deuxième couche (9) agencée sur la première couche (8), la première couche (8) étant interposée entre le substrat (3) et la deuxième couche (9), la première couche (8) comportant une partie des éléments de forme allongée (6) et la deuxième couche (9) comportant une autre partie des éléments de forme allongée (6), les particules électriquement conductrices (4) et le matériau électriquement conducteur (5).

5. Dispositif selon l'une quelconque des revendications 1 à 2, **caractérisé en ce que** l'organe électriquement conducteur (2) comporte un empilement de couches comportant une première couche (8) et une deuxième couche (9) agencée sur la première couche (8), la première couche (8) étant interposée entre le substrat (3) et la deuxième couche (9), la première couche (8) comportant les éléments de forme allongée (6) et la deuxième couche (9) comportant les particules électriquement conductrices (4) et le matériau électriquement conducteur (5).

6. Dispositif selon l'une quelconque des revendications 1 à 2, **caractérisé en ce que** l'organe électriquement conducteur (2) comporte un empilement de couches comprenant une couche (10) comportant les particules électriquement conductrices (4), une couche (11) comportant le matériau électriquement conducteur, et une couche (12) comportant les éléments de forme allongée (6).

7. Dispositif selon l'une quelconque des revendications 1 à 2, **caractérisé en ce que** l'organe électriquement conducteur (2) comporte des premières parties (13) comportant chacune une partie correspondante des particules électriquement conductrices (4), et des deuxièmes parties (14) comportant chacune une partie correspondante des éléments de forme allongée (6), le matériau électriquement conducteur (5) étant présent dans les premières parties (13) et/ou dans les deuxièmes parties (14), et **en ce que** l'organe électriquement conducteur (2) comporte un empilement de couches comportant :
- une première couche (15) munie d'au moins une des premières parties (13) et d'au moins une des deuxièmes parties (14),
- une deuxième couche (16) agencée sur la première couche (15) et munie d'au moins une des premières parties (13) et d'au moins une des deuxièmes parties (14),
chaque deuxième partie (14) étant à distance des autres deuxièmes parties (14).

8. Dispositif selon l'une quelconque des revendications précédentes, **caractérisé en ce que** le substrat (3) présente, à son interface avec l'organe électriquement conducteur (2), une structuration en creux.

9. Dispositif selon l'une quelconque des revendications précédentes, **caractérisé en ce que** les éléments de forme allongée (6) sont formés par des nanofils et/ou des nanotubes et/ou des feuillets de graphène, et/ou des éléments de forme allongée (6) comportant une âme (6a) en polymère recouverte en tout ou partie par une couche électriquement conductrice (6b).

10. Dispositif selon l'une quelconque des revendications précédentes, **caractérisé en ce que** les éléments de forme allongée (6) ont une longueur strictement supérieure à la taille des particules électriquement conductrices (4).

11. Procédé d'utilisation d'un dispositif selon l'une quelconque des revendications précédentes, comportant une phase de thermoformage (Ph1) comportant :
- une étape de chauffe (E1) dudit dispositif de sorte à autoriser une mise en forme du substrat (3) du dispositif,
- une étape de mise en forme (E2) du substrat (3) selon une forme prédéterminée au cours de laquelle ledit organe électriquement conducteur reste lié audit substrat (3),
- une étape de refroidissement (E3) au terme de laquelle il est formé un dispositif thermoformé comportant le substrat (3) adoptant la forme prédéterminée.

12. Procédé selon la revendication précédente, **caractérisé en ce qu'**il comporte une étape de fourniture (E4) d'un objet (100) comportant la forme prédéterminée, l'étape de mise en forme (E2) comportant successivement :
- une étape de projection (E2-1) d'un fluide gazeux de sorte à étirer le substrat (3) du dispositif chauffé,
- une étape d'aspiration (E2-2) permettant de plaquer le dispositif (1) contre l'objet (100) de sorte que ledit dispositif épouse au moins une partie de la surface dudit objet.

13. Dispositif thermoformé comportant un substrat (3), dont la forme a été obtenue par thermoformage, et un organe électriquement conducteur (2) solidaire dudit substrat (3), l'organe électriquement conducteur (2) comportant des particules électriquement conductrices (4), et des éléments de forme allongée (6) électriquement conducteurs, **caractérisé en ce que** l'organe électriquement conducteur (2) comporte, en outre, un matériau électriquement conducteur (5) présentant une température de fusion strictement inférieure à la température de fusion des particules électriquement conductrices (4) et à la température de fusion des éléments de forme allongée (6).

14. Dispositif thermoformé selon la revendication précédente, **caractérisé en ce que** l'organe électriquement conducteur comporte un assemblage de particules électriquement conductrices (4) et d'éléments de forme allongée (6) solidarisés par du matériau électriquement conducteur (5).

15. Procédé de fabrication d'un dispositif selon l'une quelconque des revendications 1 à 10, comportant une étape de fourniture (E100) du substrat (3), et une étape de formation (E101) de l'organe électriquement conducteur mettant en œuvre au moins une étape de dépôt (E101-1) d'une encre sur le substrat (3).

## Patentansprüche

1. Vorrichtung (1), die dazu bestimmt ist, thermogeformt zu werden, umfassend ein Substrat (3), das thermogeformt werden kann, und ein elektrisch leitfähiges Organ (2), das fest mit dem Substrat (3) verbunden ist, wobei das elektrisch leitfähige Organ (2) umfasst:
- elektrisch leitfähige Partikel (4),
- elektrisch leitfähige Elemente (6) von länglicher Form, **dadurch gekennzeichnet, dass** das elektrisch leitfähige Organ (2) weiter ein elektrisch leitfähiges Material (5) umfasst, das eine Schmelztemperatur aufweist, die strikt kleiner ist als die Schmelztemperatur der elektrisch leitfähigen Partikel (4) und die Schmelztemperatur der Elemente (6) von länglicher Form.

2. Vorrichtung nach Anspruch 1, **dadurch gekennzeichnet, dass** die Elemente (6) von länglicher Form eine Länge von größer oder gleich 20 µm aufweisen, und/oder dadurch, dass mindestens eines der Elemente (6) von länglicher Form eine gebogene Konfiguration annimmt.

3. Vorrichtung nach einem der vorstehenden Ansprüche, **dadurch gekennzeichnet, dass** das elektrisch leitfähige Organ (2) mindestens ein Verbindungselement (7) umfasst, das mindestens einen Abschnitt des elektrisch leitfähigen Materials (5) umfasst, der durch Schmelzen und anschließendes Erstarren des elektrisch leitfähigen Materials (5) erhalten wird, wobei jedes Verbindungselement (7) mindestens eines der elektrisch leitfähigen Partikel (4) mit mindestens einem der Elemente (6) von länglicher Form verbindet.

4. Vorrichtung nach einem der Ansprüche 1 bis 2, **dadurch gekennzeichnet, dass** das elektrisch leitfähige Organ (2) einen Schichtstapel umfasst, der eine erste Schicht (8) und eine auf der ersten Schicht (8) angeordnete zweite Schicht (9) umfasst, wobei die erste Schicht (8) zwischen dem Substrat (3) und der zweiten Schicht (9) eingefügt ist, wobei die erste Schicht (8) einen Teil der Elemente (6) von länglicher Form umfasst und wobei die zweite Schicht (9) einen anderen Teil der Elemente (6) von länglicher Form, die elektrisch leitfähigen Partikel (4) und das elektrisch leitfähige Material (5) umfasst.

5. Vorrichtung nach einem der Ansprüche 1 bis 2, **dadurch gekennzeichnet, dass** das elektrisch leitfähige Organ (2) einen Schichtstapel umfasst, der eine erste Schicht (8) und eine auf der ersten Schicht (8) angeordnete zweite Schicht (9) umfasst, wobei die erste Schicht (8) zwischen dem Substrat (3) und der zweiten Schicht (9) eingefügt ist, wobei die erste Schicht (8) die Elemente (6) von länglicher Form umfasst und wobei die zweite Schicht (9) die elektrisch leitfähigen Partikel (4) und das elektrisch leitfähige Material (5) umfasst.

6. Vorrichtung nach einem der Ansprüche 1 bis 2, **dadurch gekennzeichnet, dass** das elektrisch leitfähige Organ (2) einen Schichtstapel umfasst, der eine Schicht (10), die die elektrisch leitfähigen Partikel (4) umfasst, eine Schicht (11), die das elektrisch leitfähige Material umfasst, und eine Schicht (12) umfasst, die die Elemente (6) von länglicher Form umfasst.

7. Vorrichtung nach einem der Ansprüche 1 bis 2, **dadurch gekennzeichnet, dass** das elektrisch leitfähige Organ (2) erste Teile (13), die jeweils einen entsprechenden Teil der elektrisch leitfähigen Partikel (4) umfassen, und zweite Teile (14) umfasst, die jeweils einen entsprechenden Teil der Elemente (6) von länglicher Form umfassen, wobei das elektrisch leitfähige Material (5) in den ersten Teilen (13) und/oder in den zweiten Teilen (14) vorhanden ist, und dadurch, dass das elektrisch leitfähige Organ (2) einen Schichtstapel umfasst, welcher umfasst:
- eine erste Schicht (15), die mit mindestens einem der ersten Teile (13) und mindestens einem der zweiten Teile (14) versehen ist,
- eine zweite Schicht (16), die auf der ersten Schicht (15) angeordnet und mit mindestens einem der ersten Teile (13) und mindestens einem der zweiten Teile (14) versehen ist, wobei jeder zweite Teil (14) von den anderen zweiten Teilen (14) beabstandet ist.

8. Vorrichtung nach einem der vorstehenden Ansprüche, **dadurch gekennzeichnet, dass** das Substrat (3) an seiner Grenzfläche zu dem elektrisch leitfähigen Organ (2) eine vertiefte Strukturierung aufweist.

9. Vorrichtung nach einem der vorstehenden Ansprüche, **dadurch gekennzeichnet, dass** die Elemente (6) von länglicher Form von Nanodrähten und/oder Nanoröhren und/oder Graphenblättern gebildet werden, und/oder Elemente (6) von länglicher Form einen Kern (6a) aus Polymer umfassen, der ganz oder zum Teil von einer elektrisch leitfähigen Schicht (6b) bedeckt ist.

10. Vorrichtung nach einem der vorstehenden Ansprüche, **dadurch gekennzeichnet, dass** die Elemente (6) von länglicher Form eine Länge aufweisen, die strikt größer ist als die Größe der elektrisch leitfähigen Partikel (4).

11. Verfahren zur Verwendung einer Vorrichtung nach einem der vorstehenden Ansprüche, das eine Phase des Thermoformens (Ph1) umfasst, welche umfasst:
- einen Schritt (E1) des Erhitzens der Vorrichtung, um ein Formen des Substrats (3) der Vorrichtung zu gestatten,
- einen Schritt (E2) des Formens des Substrats (3) gemäß einer vorbestimmten Form, in dessen Verlauf das elektrisch leitfähige Organ mit dem Substrat (3) verbunden bleibt,
- einen Schritt (E3) des Abkühlens, an dessen Ende eine thermogeformte Vorrichtung gebildet ist, die das Substrat (3) umfasst, das die vorbestimmte Form einnimmt.

12. Verfahren nach dem vorstehenden Anspruch, **dadurch gekennzeichnet, dass** es einen Schritt (E4) des Bereitstellens eines Objekts (100) umfasst, das die vorbestimmte Form umfasst, wobei der Schritt (E2) des Formens nacheinander umfasst:
- einen Schritt (E2-1) des Spritzens eines gasförmigen Fluids, um das Substrat (3) der erhitzten Vorrichtung zu strecken
- einen Schritt (E2-2) des Ansaugens, der es ermöglicht, die Vorrichtung (1) an das Objekt (100) zu drücken, sodass die Vorrichtung sich an mindestens einen Teil der Fläche des Objekts anschmiegt.

13. Thermogeformte Vorrichtung, die ein Substrat (3), dessen Form durch Thermoformen erhalten wurde, und ein elektrisch leitfähiges Organ (2) umfasst, das fest mit dem Substrat (3) verbunden ist, wobei das elektrisch leitfähige Organ (2) elektrisch leitfähige Partikel (4) und elektrisch leitfähige Elemente (6) von länglicher Form umfasst, **dadurch gekennzeichnet, dass** das elektrisch leitfähige Organ (2) weiter ein elektrisch leitfähiges Material (5) umfasst, das eine Schmelztemperatur aufweist, die strikt kleiner ist als die Schmelztemperatur der elektrisch leitfähigen Partikel (4) und die Schmelztemperatur der Elemente (6) von länglicher Form.

14. Thermogeformte Vorrichtung nach dem vorstehenden Anspruch, **dadurch gekennzeichnet, dass** das elektrisch leitfähige Organ eine Anordnung aus elektrisch leitfähigen Partikeln (4) und Elementen (6) von länglicher Form umfasst, die durch elektrisch leitfähiges Material (5) fest miteinander verbunden sind.

15. Verfahren zur Herstellung einer Vorrichtung nach einem der Ansprüche 1 bis 10, das einen Schritt (E100) des Bereitstellens des Substrats (3) und einen Schritt (E101) des Bildens des elektrisch leitfähigen Organs umfasst, der mindestens einen Schritt (E101-1) des Abscheidens einer Tinte auf das Substrat (3) zum Einsatz bringt.

## Claims

1. A device (1) intended to be thermoformed including a substrate (3) capable of being thermoformed and an electrically conductive member (2) secured to said substrate (3), the electrically conductive member (2) including:
- electrically conductive particles (4),
- elongated electrically conductive elements (6),
**characterized in that** the electrically conductive member (2) further includes an electrically conductive material (5) having a melting temperature strictly lower than the melting temperature of the electrically conductive particles (4) and the melting temperature of the elongated elements (6).

2. The device according to claim 1, **characterized in that** the elongated elements (6) have a length greater than or equal to 20 µm, and/or **in that** at least one of the elongated elements (6) assumes a folded configuration.

3. The device according to any one of the preceding claims, **characterized in that** the electrically conductive member (2) includes at least one connecting element (7) including at least one portion of the electrically conductive material (5), obtained by melting and then solidifying the electrically conductive material (5), each connecting element (7) connecting at least one of the electrically conductive particles (4) to at least one of the elongated elements (6).

4. The device according to any one of claims 1 and 2, **characterized in that** the electrically conductive member (2) includes a stack of layers including a first layer (8) and a second layer (9) arranged on the first layer (8), the first layer (8) being interposed between the substrate (3) and the second layer (9), the first layer (8) including a part of the elongated elements (6) and the second layer (9) including another part of the elongated elements (6), the electrically conductive particles (4) and the electrically conductive material (5).

5. The device according to any one of claims 1 and 2, **characterized in that** the electrically conductive member (2) includes a stack of layers including a first layer (8) and a second layer (9) arranged on the first layer (8), the first layer (8) being interposed between the substrate (3) and the second layer (9), the first layer (8) including the elongated elements (6) and the second layer (9) including the electrically conductive particles (4) and the electrically conductive material (5).

6. The device according to any one of claims 1 and 2, **characterized in that** the electrically conductive member (2) includes a stack of layers comprising a layer (10) including the electrically conductive particles (4), a layer (11) including the electrically conductive material, and a layer (12) including the elongated elements (6).

7. The device according to any one of claims 1 and 2, **characterized in that** the electrically conductive member (2) includes first parts (13) each including a corresponding part of the electrically conductive particles (4), and second parts (14) each including a corresponding part of the elongated elements (6), the electrically conductive material (5) being present in the first parts (13) and/or in the second parts (14), and **in that** the electrically conductive member (2) includes a stack of layers including :
- a first layer (15) provided with at least one of the first parts (13) and at least one of the second parts (14),
- a second layer (16) arranged on the first layer (15) and provided with at least one of the first parts (13) and at least one of the second parts (14),
each second part (14) being spaced from the other second parts (14).

8. The device according to any one of the preceding claims, **characterized in that** the substrate (3) has, at its interface with the electrically conductive member (2), a hollow structure.

9. The device according to any one of the preceding claims, **characterized in that** the elongated elements (6) are formed by nanowires and/or nanotubes and/or graphene sheets, and/or elongated elements (6) including a polymer core (6a) covered in whole or in part by an electrically conductive layer (6b).

10. The device according to any one of the preceding claims, **characterized in that** the elongated elements (6) have a length strictly greater than the size of the electrically conductive particles (4).

11. A method for using a device according to any one of the preceding claims, including a thermoforming phase (Ph1) including:
- a step of heating (E1) said device so as to allow shaping of the substrate (3) of the device,
- a step of shaping (E2) the substrate (3) into a predetermined shape during which said electrically conductive member remains bonded to said substrate (3),
- a cooling step (E3) at the end of which a thermoformed device including the substrate (3) assuming the predetermined shape is formed.

12. The method according to the preceding claim, **characterized in that** it includes a step of providing (E4) an object (100) having the predetermined shape, the shaping step (E2) successively including:
- a step of projecting (E2-1) a gaseous fluid so as to stretch the substrate (3) of the heated device,
- a suction step (E2-2) allowing pressing the device (1) against the object (100) so that said device conforms to at least one part of the surface of said object.

13. A thermoformed device including a substrate (3), the shape of which has been obtained by thermoforming, and an electrically conductive member (2) secured to said substrate (3), the electrically conductive member (2) including electrically conductive particles (4), and elongated electrically conductive elements (6), **characterized in that** the electrically conductive member (2) further includes an electrically conductive material (5) having a melting temperature strictly lower than the melting temperature of the electrically conductive particles (4) and the melting temperature of the elongated elements (6).

14. The thermoformed device according to the preceding claim, **characterized in that** the electrically conductive member includes an assembly of electrically conductive particles (4) and elongated elements (6) secured by electrically conductive material (5).

15. A method for manufacturing a device according to any one of claims 1 to 10, including a step of providing (E100) the substrate (3), and a step of forming (E101) the electrically conductive member implementing at least one step of depositing (E101-1) an ink on the substrate (3).
